# EUROPEAN PATENT APPLICATION

(11) **EP 4 773 772 A1**
(43) Date of publication of application: **08.07.2026**
(21) Application number: 25220138.9
(22) Date of filing: 02.12.2025
(51) Int. Cl.: H10K 59/123, H10K 59/124, H10K 59/80, H10K 59/12, H10K 59/122

(54) **DISPLAY DEVICE, ELECTRONIC DEVICE AND METHOD FOR FABRICATING DISPLAY DEVICE**

(30) Priority: 02.01.2025 KR 20250000115
(71) Applicant: Samsung Display Co., Ltd., Yongin-si, Gyeonggi-do 17113 (KR)
(72) Inventor: LEE, Chang Ho, Yongin-si (KR)
(74) Representative: Marks & Clerk LLP

(57) **Abstract**

A display device including a substrate, an insulating layer above the substrate, a via electrode within a via hole of the insulating layer, a planarization layer defining a through hole overlapping the via electrode and a portion of the insulating layer around the via electrode, a connection electrode above the planarization layer in the through hole, a reflective electrode above the connection electrode in the through hole, an optical auxiliary layer above the reflective electrode, a first electrode above the optical auxiliary layer, and having an edge facing an edge of the connection electrode and contacting the edge of the connection electrode without a step, a light-emitting stack above the first electrode, and a second electrode above the light-emitting stack.

## Description

### BACKGROUND

### 1. Field

The present disclosure relates to a display device, an electronic device, and a method for fabricating a display device capable of reducing or preventing the likelihood of damage to an anode electrode.

### 2. Description of the Related Art

An organic light-emitting display device includes a display element whose luminance is changed by current, for example, an organic light-emitting diode.

### SUMMARY

Aspects of the present disclosure provide a display device, an electronic device, and a method for fabricating a display device capable of reducing or preventing the likelihood of damage to an anode electrode.

According to an aspect of the present disclosure, there is provided a display device including a substrate, an insulating layer above the substrate, a via electrode within a via hole of the insulating layer, a planarization layer defining a through hole overlapping the via electrode and a portion of the insulating layer around the via electrode, a connection electrode above the planarization layer in the through hole, a reflective electrode above the connection electrode in the through hole, an optical auxiliary layer above the reflective electrode, a first electrode above the optical auxiliary layer, and having an edge facing an edge of the connection electrode and contacting the edge of the connection electrode without a step, a light-emitting stack above the first electrode, and a second electrode above the light-emitting stack.

The edge of the first electrode may be above the edge of the connection electrode.

The connection electrode may include a first lower electrode above the via electrode and the insulating layer within the through hole of the planarization layer, a first side electrode on an inner wall defining the through hole of the planarization layer, and connected to the first lower electrode, and a first upper electrode above the planarization layer, and connected to the first side electrode, and wherein the edge of the connection electrode includes the first upper electrode.

The first electrode may include a second lower electrode above the first upper electrode of the connection electrode, a second side electrode on a side surface of the optical auxiliary layer, and connected to the second lower electrode, and a second upper electrode above an upper surface of the optical auxiliary layer, and connected to the second side electrode, and wherein the edge of the first electrode includes the second lower electrode.

The second lower electrode and the first upper electrode may face each other, and contact each other without a step.

An interface between the second lower electrode and the first upper electrode may be aligned with an interface between the optical auxiliary layer and the reflective electrode.

An interface between the second lower electrode and the first upper electrode and an interface between the optical auxiliary layer and the reflective electrode may extend along an imaginary straight line.

The first lower electrode may be on a lower surface of the reflective electrode, wherein the first side electrode is on a side surface of the reflective electrode.

The first upper electrode may surround the reflective electrode in plan view.

The second lower electrode may be above the first upper electrode and surrounds the optical auxiliary layer in plan view.

A thickness of the second side electrode may be less than a thickness of the second upper electrode.

The reflective electrode may be surrounded by the connection electrode and the optical auxiliary layer.

The optical auxiliary layer may be surrounded by the first electrode and the reflective electrode.

The optical auxiliary layer may have different respective thicknesses for multiple sub-pixels.

The display device may further include a pixel-defining layer defining a light-emitting area above the first electrode, and a separator above the pixel-defining layer, wherein the light-emitting stack is cut along the separator.

According to another aspect of the present disclosure, there is provided an electronic device including a display device for providing a display screen, and including a substrate, an insulating layer above the substrate, a via electrode within a via hole of the insulating layer, a planarization layer defining a through hole overlapping the via electrode and a portion of the insulating layer around the via electrode, a connection electrode above the planarization layer and in the through hole of the planarization layer, a reflective electrode above the connection electrode and in the through hole, an optical auxiliary layer above the reflective electrode, a first electrode above the optical auxiliary layer, and having an edge facing an edge of the connection electrode and contacting the edge of the connection electrode without a step, a light-emitting stack above the first electrode, and a second electrode above the light-emitting stack.

The connection electrode may include a first lower electrode above the via electrode and the insulating layer in the through hole of the planarization layer, a first side electrode on an inner wall defining the through hole of the planarization layer, and connected to the first lower electrode, and a first upper electrode above the planarization layer, and connected to the first side electrode, and wherein the edge of the connection electrode includes the first upper electrode.

The first electrode may include a second lower electrode above the first upper electrode of the connection electrode, a second side electrode on a side surface of the optical auxiliary layer, and connected to the second lower electrode, and a second upper electrode above an upper surface of the optical auxiliary layer, and connected to the second side electrode, wherein the edge of the first electrode includes the second lower electrode, and wherein the second lower electrode and the first upper electrode contact each other without a step.

The electronic device may include a smartphone, a tablet, a laptop, a TV, a desk monitor, smart glasses, a smart watch, a head-mounted display, or a vehicle.

According to still another aspect of the present disclosure, there is provided a method for fabricating a display device, the method including forming an insulating layer having a via electrode therein above a substrate, forming a planarization layer above the via electrode and the insulating layer, forming a through hole in the planarization layer that exposes the via electrode and a portion of the insulating layer around the via electrode, forming a connection electrode layer above the planarization layer, above the via electrode the portion of the insulating layer exposed through the through hole, and on an inner wall defining the through hole, forming a reflective electrode layer above the connection electrode layer, forming a reflective electrode in the through hole by removing a portion of the reflective electrode layer above the planarization layer, forming a connection electrode inside the through hole by removing a portion of the connection electrode layer above the planarization layer, forming an optical auxiliary layer above the reflective electrode, forming a first electrode above the optical auxiliary layer and having an edge facing an edge of the connection electrode and contacting the edge of the connection electrode without a step, forming a light-emitting stack above the first electrode, and forming a second electrode above the light-emitting stack.

At least some of the above and other features of the invention are set out in the claims.

According to one or more embodiments, damage to the anode electrode may be reduced or prevented.

For example, according to one or more embodiments, the lower electrode of the anode electrode may contact the upper electrode of the connection electrode without bending (and/or without a step or height difference). Therefore, the possibility of damage (e.g., short circuit) to the anode electrode may be reduced or minimized.

The aspects of the present disclosure are not limited to the above-described aspects, and other aspects that are not described herein will become apparent to those skilled in the art from the following description.

### BRIEF DESCRIPTION OF THE DRAWINGS

The above and other aspects of the present disclosure will become more apparent by describing in detail embodiments thereof with reference to the attached drawings, in which:
FIG. 1 is an exploded perspective view illustrating a display device according to one or more embodiments;
FIG. 2 is a block diagram illustrating the display device according to one or more embodiments;
FIG. 3 is an equivalent circuit diagram of a first sub-pixel according to one or more embodiments;
FIG. 4 is a layout diagram illustrating an example of a display panel according to one or more embodiments;
FIGS. 5 and 6 are layout diagrams illustrating examples of a display area of FIG. 4;
FIG. 7 is a cross-sectional view illustrating an example of the display panel taken along the line l1-l1' of FIG. 5;
FIG. 8 is a cross-sectional view illustrating area A1 of FIG. 7 in detail;
FIG. 9 is a cross-sectional view illustrating area A2 of FIG. 8 in detail;
FIGS. 10, 11, 12, 13, 14, 15, 16, 17, 18, 19, 20, 21, and 22 are process diagrams for describing a method for fabricating a display device according to one or more embodiments;
FIG. 23 is a block diagram of an electronic display device according to one or more embodiments; and
FIGS. 24, 25, and 26 are schematic diagrams of electronic devices according to various embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions, such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions, such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

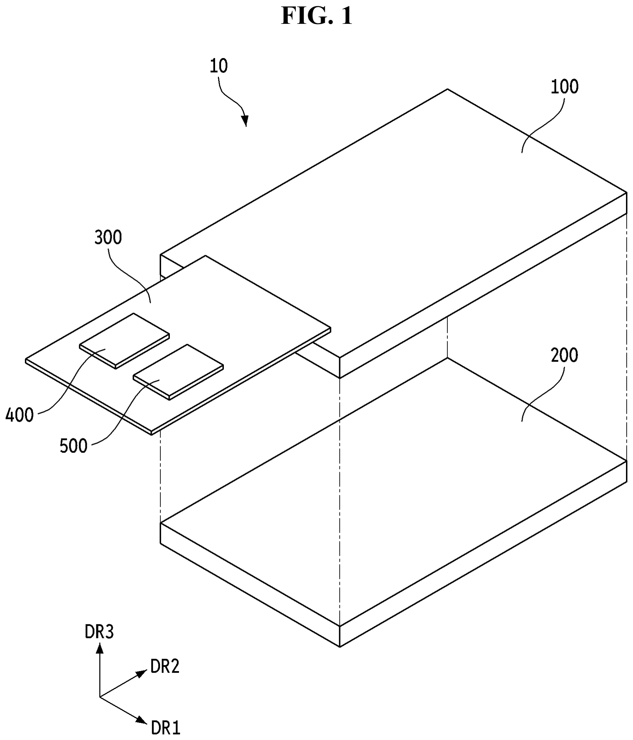

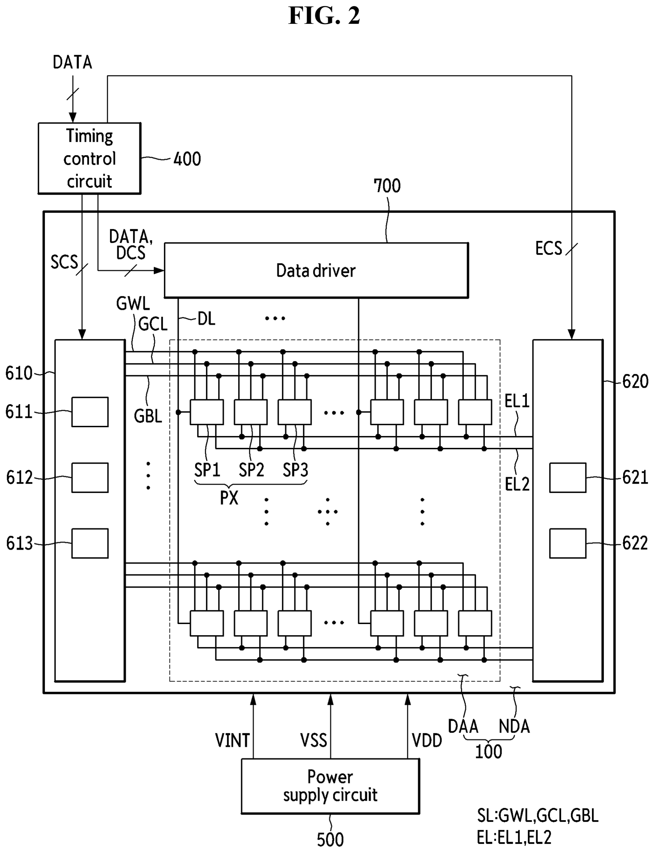

FIG. 1 is an exploded perspective view illustrating a display device according to one or more embodiments. FIG. 2 is a block diagram illustrating the display device according to one or more embodiments.

Referring to FIGS. 1 and 2, a display device 10 according to one or more embodiments is a device displaying a moving image or a still image. The display device 10 according to one or more embodiments may be applied to portable electronic devices, such as a mobile phone, a smart phone, a tablet personal computer (PC), a mobile communication terminal, an electronic notebook, an electronic book, a portable multimedia player (PMP), navigation, and an ultra-mobile PC (UMPC). For example, the display device 10 according to one or more embodiments may be applied to a display unit of a television, a laptop computer, a monitor, a billboard, or the Internet of Things (IoT). Alternatively, the display device 10 according to one or more embodiments may be applied to a smart watch, a watch phone, and a head-mounted display (HMD) for implementing virtual reality and augmented reality.

The display device 10 according to one or more embodiments includes a display panel 100, a heat dissipation layer 200, a circuit board 300, a timing control circuit 400, and a power supply circuit 500.

The display panel 100 may be formed in a planar shape similar to a quadrangle. For example, the display panel 100 may have a planar shape similar to a quadrangle having short sides in a first direction DR1, and long sides in a second direction DR2 crossing the first direction DR1. In the display panel 100, a corner where the short side in the first direction DR1 and the long side in the second direction DR2 meet may be rounded to have a curvature (e.g., predetermined curvature) or may be formed at a right angle. The planar shape of the display panel 100 is not limited to the quadrangle, and may be formed similarly to other polygons, circles, or ovals. A planar shape of the display device 10 may follow the planar shape of the display panel 100, but the present disclosure is not limited thereto.

The display panel 100 includes a plurality of pixels PX, a plurality of scan lines SL, a plurality of emission control lines EL, a plurality of data lines DL, a scan driver 610, a light-emitting driver 620, and a data driver 700. The display panel 100 may be divided into a display area DAA displaying an image and a non-display area NDA that does not display an image, as illustrated in FIG. 2.

The plurality of pixels PX may be located in the display area DAA. The plurality of pixels PX may be arranged in a matrix form in the first direction DR1 and the second direction DR2. The plurality of scan lines SL and the plurality of emission control lines EL may extend in the first direction DR1, and may be arranged in the second direction DR2. The plurality of data lines DL may extend in the second direction DR2, and may be arranged in the first direction DR1.

The plurality of scan lines SL includes a plurality of write scan lines GWL, a plurality of control scan lines GCL, and a plurality of bias scan lines GBL. The plurality of emission control lines EL include a plurality of first emission control lines EL1 and a plurality of second emission control lines EL2.

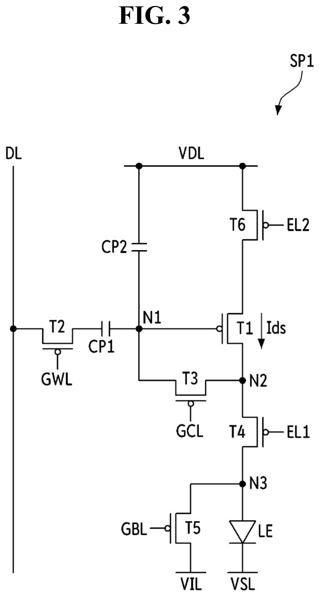

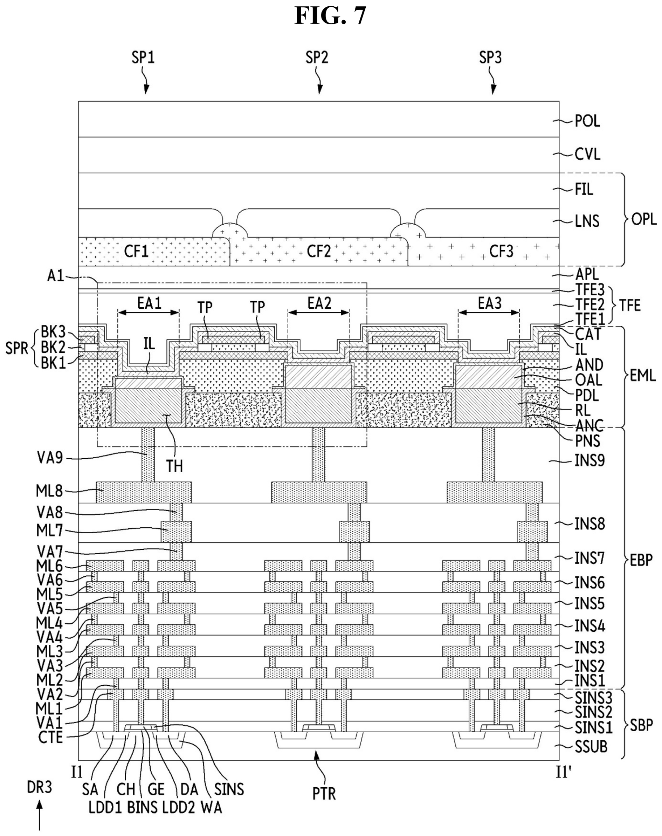

The plurality of pixels PX includes a plurality of sub-pixels SP1, SP2, and SP3. The plurality of sub-pixels SP1, SP2, and SP3 may include a plurality of pixel transistors as illustrated in FIG. 3, and the plurality of pixel transistors may be formed through a semiconductor process and may be located on a semiconductor substrate (SSUB in FIG. 7) (as used herein, "located on" may mean "above"). For example, the plurality of pixel transistors of the data driver 700 may be formed of a Complementary Metal Oxide Semiconductor (CMOS), but the present disclosure is not limited thereto.

Each of the plurality of sub-pixels SP1, SP2, and SP3 may be connected to any one write scan line GWL among the plurality of write scan lines GWL, any one control scan line GCL among the plurality of control scan lines GCL, any one bias scan line GBL among the plurality of bias scan lines GBL, any one first emission control line EL1 among the plurality of first emission control lines EL1, any one second emission control line EL2 among the plurality of second emission control lines EL2, and any one data line DL among the plurality of data lines DL. Each of the plurality of sub-pixels SP1, SP2, and SP3 may receive a data voltage of the data line DL according to a write scan signal of the write scan line GWL, and may emit light from a light-emitting element according to the data voltage.

The scan driver 610, the light-emitting driver 620, and the data driver 700 may be located in the non-display area NDA.

The scan driver 610 includes a plurality of scan transistors, and the light-emitting driver 620 includes a plurality of light-emitting transistors. The plurality of scan transistors and the plurality of light-emitting transistors may be formed through a semiconductor process, and may be formed on a semiconductor substrate (SSUB in FIG. 7). For example, the plurality of scan transistors and the plurality of light-emitting transistors may be formed of CMOS, but the present disclosure is not limited thereto.

The scan driver 610 may include a write scan signal output unit 611, a control scan signal output unit 612, and/or a bias scan signal output unit 613. Each of the write scan signal output unit 611, the control scan signal output unit 612, and the bias scan signal output unit 613 may receive a scan-timing control signal SCS from the timing control circuit 400. The write scan signal output unit 611 may generate write scan signals according to the scan-timing control signal SCS of the timing control circuit 400 and sequentially output the write scan signals to the write scan lines GWL. The control scan signal output unit 612 may generate control scan signals according to the scan-timing control signal SCS and sequentially output the control scan signals to the control scan lines GCL. The bias scan signal output unit 613 may generate bias scan signals according to the scan-timing control signal SCS and sequentially output the bias scan signals to the bias scan lines GBL.

The light-emitting driver 620 includes a first emission control driver 621 and a second emission control driver 622. Each of the first emission control driver 621 and the second emission control driver 622 may receive an emission-timing control signal ECS from the timing control circuit 400. The first emission control driver 621 may generate first emission control signals according to the emission-timing control signal ECS and sequentially output the first emission control signals to the first emission control lines EL1. The second emission control driver 622 may generate second emission control signals according to the emission-timing control signal ECS and sequentially output the second emission control signals to the second emission control lines EL2.

The data driver 700 may include a plurality of data transistors, and the plurality of data transistors may be formed through a semiconductor process and may be formed on a semiconductor substrate (SSUB in FIG. 7). For example, the plurality of data transistors may be formed of CMOS, but the present disclosure is not limited thereto.

The data driver 700 may receive digital video data DATA and a data-timing control signal DCS from the timing control circuit 400. The data driver 700 converts the digital video data DATA into analog data voltages according to the data-timing control signal DCS and outputs the converted analog data voltages to the data lines DL. In this case, the sub-pixels SP1, SP2, and SP3 may be selected by the write scan signals of the scan driver 610, and the data voltages may be supplied to the selected sub-pixels SP1, SP2, and SP3.

The heat dissipation layer 200 may overlap the display panel 100 in the third direction DR3, which is a thickness direction of the display panel 100. The heat dissipation layer 200 may be located on one surface of the display panel 100, for example, a rear surface of the display panel 100. The heat dissipation layer 200 serves to dissipate heat generated from the display panel 100. The heat dissipation layer 200 may include a metal layer, such as graphite, silver (Ag), copper (Cu), or aluminium (Al) having high thermal conductivity.

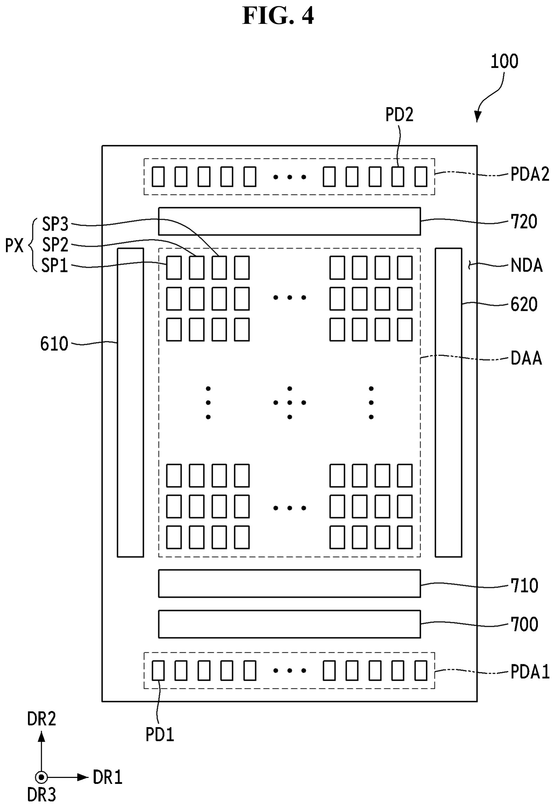

The circuit board 300 may be electrically connected to a plurality of first pads (PD1 in FIG. 4) of a first pad portion (PDA1 in FIG. 4) of the display panel 100 by using a conductive adhesive member, such as an anisotropic conductive film. The circuit board 300 may be a flexible printed circuit board or flexible film made of a flexible material. It is illustrated in FIG. 1 that the circuit board 300 is unfolded, but the circuit board 300 may be bent. In this case, one end of the circuit board 300 may be located on the rear surface of the display panel 100 and/or a rear surface of the heat dissipation layer 200. The other end of the circuit board 300 may be connected to a plurality of first pads (PD1 in FIG. 4) of a first pad portion (PDA1 in FIG. 4) of the display panel 100 by using a conductive adhesive member. One end of the circuit board 300 may be an end opposite to the other end of the circuit board 300.

The timing control circuit 400 may receive digital video data and timing signals from the outside. The timing control circuit 400 may generate a scan-timing control signal SCS, an emission-timing control signal ECS, and a data-timing control signal DCS for controlling the display panel 100 according to the timing signals. The timing control circuit 400 may output the scan-timing control signal SCS to the scan driver 610 and output the emission-timing control signal ECS to the light-emitting driver 620. The timing control circuit 400 may output the digital video data and the data-timing control signal DCS to the data driver 700.

The power supply circuit 500 may generate a plurality of panel driving voltages according to a power voltage from the outside. For example, the power supply circuit 500 may generate a first driving voltage VSS, a second driving voltage VDD, and a third driving voltage VINT, and may supply the generated driving voltages to the display panel 100. The first driving voltage VSS, the second driving voltage VDD, and the third driving voltage VINT will be described later with reference to FIG. 3.

Each of the timing control circuit 400 and the power supply circuit 500 may be formed as an integrated circuit (IC) and attached to one surface of the circuit board 300. In this case, the scan-timing control signal SCS, the emission-timing control signal ECS, the digital video data DATA, and the data-timing control signal DCS of the timing control circuit 400 may be supplied to the display panel 100 through the circuit board 300. In addition, the first driving voltage VSS, the second driving voltage VDD, and the third driving voltage VINT of the power supply circuit 500 may be supplied to the display panel 100 through the circuit board 300.

Alternatively, each of the timing control circuit 400 and the power supply circuit 500 may be located in the non-display area NDA of the display panel 100, similarly to the scan driver 610, the light-emitting driver 620, and the data driver 700. In this case, the timing control circuit 400 may include a plurality of timing transistors, and each of the power supply circuits 500 may include a plurality of power transistors. The plurality of timing transistors and the plurality of power transistors may be formed through a semiconductor process, and may be formed on a semiconductor substrate (SSUB in FIG. 7). For example, the plurality of timing transistors and the plurality of power transistors may be formed of CMOS, but the present disclosure is not limited thereto. Each of the timing control circuit 400 and the power supply circuit 500 may be located between the data driver 700 and the first pad portion (PDA1 in FIG. 4).

FIG. 3 is an equivalent circuit diagram of a first sub-pixel according to one or more embodiments.

Referring to FIG. 3, a first sub-pixel SP1 may be connected to the write scan line GWL, the control scan line GCL, the bias scan line GBL, the first emission control line EL1, the second emission control line EL2, and the data line DL. In addition, the first sub-pixel SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be a voltage lower than the third driving voltage VINT. The second driving voltage VDD may be a voltage higher than the third driving voltage VINT.

The first sub-pixel SP1 includes a plurality of transistors T1 to T6, a light-emitting element LE, a first capacitor CP1, and a second capacitor CP2.

The light-emitting element LE emits light according to a driving current Ids flowing through a channel of a first transistor T1. An amount of light emitted from the light-emitting element LE may be proportional to the driving current Ids. The light-emitting element LE may be located between a fourth transistor T4 and the first driving voltage line VSL. A first electrode of the light-emitting element LE may be connected to a drain electrode of the fourth transistor T4, and a second electrode thereof may be connected to the first driving voltage line VSL. The first electrode of the light-emitting element LE may be an anode electrode, and the second electrode of the light-emitting element LE may be a cathode electrode. The light-emitting element LE may be an organic light-emitting diode including a first electrode, a second electrode, and an organic light-emitting layer located between the first electrode and the second electrode, but the present disclosure is not limited thereto. For example, the light-emitting element LE may be an inorganic light-emitting element including a first electrode, a second electrode, and an inorganic semiconductor located between the first electrode and the second electrode. In this case, the light-emitting element LE may be a micro light-emitting diode.

The first transistor T1 may be a driving transistor that controls a source-drain current Ids (hereinafter, referred to as "driving current") flowing between a source electrode and a drain electrode according to a voltage applied to a gate electrode. The first transistor T1 includes a gate electrode connected to a first node N1, a source electrode connected to a drain electrode of a sixth transistor T6, and a drain electrode connected to a second node N2.

A second transistor T2 may be located between one electrode of the first capacitor CP1 and the data line DL. The second transistor T2 is turned on by the write scan signal of the write scan line GWL, and connects one electrode of the first capacitor CP1 to the data line DL. Accordingly, the data voltage of the data line DL may be applied to one electrode of the first capacitor CP1. The second transistor T2 includes a gate electrode connected to the write scan line GWL, a source electrode connected to the data line DL, and a drain electrode connected to one electrode of the first capacitor CP1.

A third transistor T3 may be located between the first node N1 and the second node N2. The third transistor T3 is turned on by the write control signal of the control scan line GCL, and connects the first node N1 to the second node N2. Accordingly, when the gate electrode and the source electrode of the first transistor T1 are connected, the first transistor T1 may operate like a diode. The third transistor T3 includes a gate electrode connected to the control scan line GCL, a source electrode connected to the second node N2, and a drain electrode connected to the first node N1.

A fourth transistor T4 may be connected between the second node N2 and a third node N3. The fourth transistor T4 is turned on by the first emission control signal of the first emission control line EL1, and connects the second node N2 to the third node N3. Accordingly, the driving current of the first transistor T1 may be supplied to the light-emitting element LE. The fourth transistor T4 includes a gate electrode connected to the first emission control line EL1, a source electrode connected to the second node N2, and a drain electrode connected to the third node N3.

A fifth transistor T5 may be located between the third node N3 and the third driving voltage line VIL. The fifth transistor T5 is turned on by the bias scan signal of the bias scan line GBL, and connects the third node N3 to the third driving voltage line VIL. Accordingly, the third driving voltage VINT of the third driving voltage line VIL may be applied to the first electrode of the light-emitting element LE. The fifth transistor T5 includes a gate electrode connected to the bias scan line GBL, a source electrode connected to the third node N3, and a drain electrode connected to the third driving voltage line VIL.

A sixth transistor T6 may be located between the source electrode of the first transistor T1 and the second driving voltage line VDL. The sixth transistor T6 is turned on by the second emission control signal of the second emission control line EL2, and connects the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor CP1 is formed between the first node N1 and the drain electrode of the second transistor T2. The first capacitor CP1 includes one electrode connected to the drain electrode of the second transistor T2 and the other electrode connected to the first node N1.

The second capacitor CP2 is formed between the gate electrode of the first transistor T1 and the second driving voltage line VDL. The second capacitor CP2 includes one electrode connected to the gate electrode of the first transistor T1 and the other electrode connected to the second driving voltage line VDL.

The first node N1 is a contact point of the gate electrode of the first transistor T1, the drain electrode of the third transistor T3, the other electrode of the first capacitor CP1, and one electrode of the second capacitor CP2. The second node N2 is a contact point of the drain electrode of the first transistor T1, the source electrode of the third transistor T3, and the source electrode of the fourth transistor T4. The third node N3 is a contact point of the drain electrode of the fourth transistor T4, the source electrode of the fifth transistor T5, and the first electrode of the light-emitting element LE.

Each of the first to sixth transistors T1 to T6 may be a metal-oxide-semiconductor field effect transistor (MOSFET). For example, each of the first to sixth transistors T1 to T6 may be a P-type MOSFET, but the present disclosure is not limited thereto. Each of the first to sixth transistors T1 to T6 may be an N-type MOSFET. Alternatively, each of some of the first to sixth transistors T1 to T6 may be a P-type MOSFET, and each of the remaining transistors may be an N-type MOSFET.

It is illustrated in FIG. 3 that the first sub-pixel SP1 includes the six transistors T1 to T6 and the two capacitors CP1 and CP2, but it should be noted that the equivalent circuit diagram of the first sub-pixel SP1 is not limited to that illustrated in FIG. 3. For example, the number of transistors and capacitors of the first sub-pixel SP1 is not limited to that illustrated in FIG. 3.

In addition, an equivalent circuit diagram of a second sub-pixel SP2 and an equivalent circuit diagram of a third sub-pixel SP3 may be substantially the same as the equivalent circuit diagram of the first sub-pixel SP1 described with reference to FIG. 3. Therefore, the descriptions of the equivalent circuit diagram of the second sub-pixel SP2 and the equivalent circuit diagram of the third sub-pixel SP3 are omitted in the present specification.

FIG. 4 is a layout diagram illustrating an example of a display panel according to one or more embodiments.

Referring to FIG. 4, the display area DAA of the display panel 100 according to one or more embodiments includes a plurality of pixels PX arranged in a matrix form. The non-display area NDA of the display panel 100 according to one or more embodiments includes a scan driver 610, a light-emitting driver 620, a data driver 700, a first distribution circuit 710, a second distribution circuit 720, a first pad portion PDA1, and a second pad portion PDA2.

The scan driver 610 may be located on a first side of the display area DAA, and the light-emitting driver 620 may be located on a second side of the display area DAA. For example, the scan driver 610 may be located on one side of the display area DAA in the first direction DR1, and the light-emitting driver 620 may be located on the other side of the display area DAA in the first direction DR1. That is, the scan driver 610 may be located on a left side of the display area DAA, and the light-emitting driver 620 may be located on a right side of the display area DAA. However, the present disclosure is not limited thereto, and the scan driver 610 and the light-emitting driver 620 may be located on both the first side and the second side of the display area DAA.

The first pad portion PDA1 may include a plurality of first pads PD1 connected to pads or bumps of the circuit board 300 through a conductive adhesive member. The first pad portion PDA1 may be located on a third side of the display area DAA. For example, the first pad portion PDA1 may be located on one side of the display area DAA in the second direction DR2. The first pad portion PDA1 may be located on the outside of the data driver 700 in the second direction DR2. That is, the first pad portion PDA1 may be located closer to an edge of the display panel 100 than the data driver 700.

The second pad portion PDA2 may include a plurality of second pads PD2 corresponding to test pads for testing whether the display panel 100 is normally operating. The plurality of second pads PD2 may be connected to a jig or probe pin or to a test circuit board during the test process. The test circuit board may be a printed circuit board made of a rigid material or a flexible printed circuit board made of a flexible material.

The second pad portion PDA2 may be located on a fourth side of the display area DAA. For example, the second pad portion PDA2 may be located on the other side of the display area DAA in the second direction DR2. The second pad portion PDA2 may be located on the outside of the second distribution circuit 720 in the second direction DR2. That is, the second pad portion PDA2 may be located closer to the edge of the display panel 100 than the second distribution circuit 720.

The first distribution circuit 710 distributes the data voltages applied through the first pad portion PDA1 to the plurality of data lines DL. For example, the first distribution circuit 710 may distribute data voltages applied through one first pad PD1 of the first pad portion PDA1 to P (P is a positive integer greater than or equal to 2) data lines DL, thereby reducing the number of first pads PD1. The first distribution circuit 710 may be located on a third side of the display area DAA of the display panel 100. For example, the first distribution circuit 710 may be located on one side of the display area DAA in the second direction DR2. That is, the first distribution circuit 710 may be located on a lower side of the display area DAA.

The second distribution circuit 720 distributes signals applied through the second pad portion PDA2 to the scan driver 610, the light-emitting driver 620, and the data lines DL. The second pad portion PDA2 and the second distribution circuit 720 may be components for testing the operation of each pixel PX of the display area DAA. The second distribution circuit 720 may be located on a fourth side of the display area DAA of the display panel 100. For example, the second distribution circuit 720 may be located on the other side of the display area DAA in the second direction DR2. That is, the second distribution circuit 720 may be located on an upper side of the display area DAA.

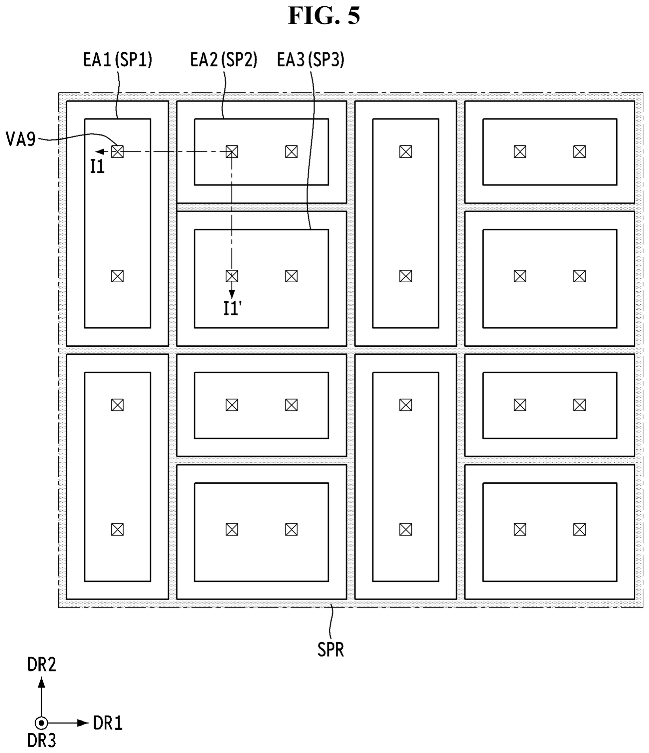

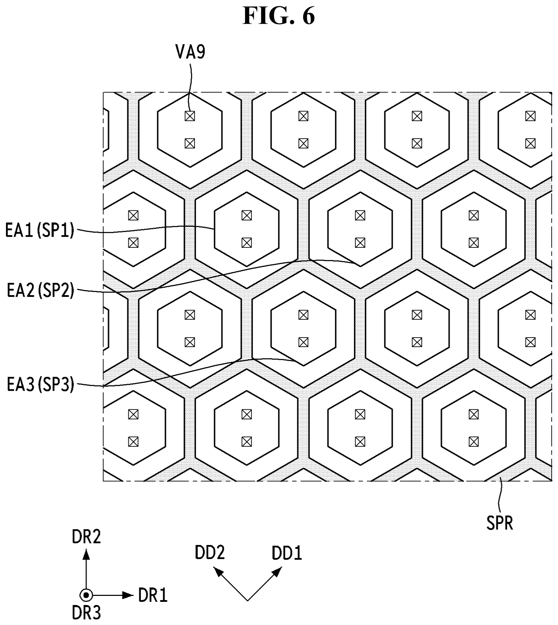

FIGS. 5 and 6 are layout diagrams illustrating examples of a display area of FIG. 4.

Referring to FIGS. 5 and 6, each of the plurality of pixels PX includes a first light-emitting area EA1, which is a light-emitting area of the first sub-pixel SP1, a second light-emitting area EA2, which is a light-emitting area of the second sub-pixel SP2, and a third light-emitting area EA3, which is a light-emitting area of the third sub-pixel SP3.

Each of the first light-emitting area EA1, the second light-emitting area EA2, and the third light-emitting area EA3 may have a polygonal, circular, elliptical, or irregular planar shape.

A maximum length of the first light-emitting area EA1 in the first direction DR1 may be less than a maximum length of the second light-emitting area EA2 in the first direction DR1 and a maximum length of the third light-emitting area EA3 in the first direction DR1. The maximum length of the second light-emitting area EA2 in the first direction DR1 and the maximum length of the third light-emitting area EA3 in the first direction DR1 may be substantially the same.

A maximum length of the first light-emitting area EA1 in the second direction DR2 may be longer than a maximum length of the second light-emitting area EA2 in the second direction DR2 and a maximum length of the third light-emitting area EA3 in the second direction DR2. The maximum length of the second light-emitting area EA2 in the second direction DR2 may be less than the maximum length of the third light-emitting area EA3 in the second direction DR2.

The first light-emitting area EA1, the second light-emitting area EA2, and the third light-emitting area EA3 may have a hexagonal planar shape including six straight lines as illustrated in FIGS. 5 and 6, but the present disclosure is not limited thereto. The first light-emitting area EA1, the second light-emitting area EA2, and the third light-emitting area EA3 have a polygonal, circular, elliptical, or irregular planar shape other than the hexagonal planar shape.

As illustrated in FIG. 5, in each of the plurality of pixels PX, the first light-emitting area EA1 and the second light-emitting area EA2 may be adjacent to each other in the first direction DR1. In addition, the first light-emitting area EA1 and the third light-emitting area EA3 may be adjacent to each other in the first direction DR1. In addition, the second light-emitting area EA2 and the third light-emitting area EA3 may be adjacent to each other in the second direction DR2. An area of the first light-emitting area EA1, an area of the second light-emitting area EA2, and an area of the third light-emitting area EA3 may be different.

Alternatively, as illustrated in FIG. 6, the first light-emitting area EA1 and the second light-emitting area EA2 are adjacent to each other in the first direction DR1, but the second light-emitting area EA2 and the third light-emitting area EA3 may be adjacent to each other in a first diagonal direction DD1, and the first light-emitting area EA1 and the third light-emitting area EA3 may be adjacent to each other in a second diagonal direction DD2. The first diagonal direction DD1, which is a direction between the first direction DR1 and the second direction DR2, may indicate a direction inclined by about 45 degrees compared to the first direction DR1 and the second direction DR2, and the second diagonal direction DD2 may be a direction substantially perpendicular to the first diagonal direction DD1.

The first sub-pixel SP1 may emit first light that has passed through a first color filter (CF1 in FIG. 7) among the light emitted from the first light-emitting area EA1, the second sub-pixel SP2 may emit second light that has passed through a second color filter (CF2 in FIG. 7) among the light emitted from the second light-emitting area EA2, and the third sub-pixel SP3 may emit first light that has passed through a third color filter (CF3 in FIG. 7) among the light emitted from the third light-emitting area EA3.

The first light, the second light, and the third light described above may be light in different respective wavelength bands. For example, one of the first to third lights may be light in a blue wavelength band, another may be light in a green wavelength band, and the remaining one may be light in a red wavelength band. Here, the blue wavelength band may indicate that a main peak wavelength of light is included in a wavelength band of approximately 370 nm to approximately 460 nm, the green wavelength band may indicate that a main peak wavelength of light is included in a wavelength band of approximately 480 nm to approximately 560 nm, and the red wavelength band may indicate that a main peak wavelength of light is included in a wavelength band of approximately 600 nm to approximately 750 nm.

It is illustrated in FIGS. 5 and 6 that each of the plurality of pixels PX includes the three light-emitting areas EA1, EA2, and EA3, but the present disclosure is not limited thereto. That is, each of the plurality of pixels PX may also include four light-emitting areas.

In addition, the arrangement of the light-emitting areas of the plurality of pixels PX is not limited to those illustrated in FIGS. 5 and 6. For example, the light-emitting areas of the plurality of pixels PX may be located in a stripe structure in which the light-emitting areas are arranged in the first direction DR1, a PenTile^{®} structure (PENTILE^{™} and PenTile^{®} being registered trademarks of Samsung Display Co., Ltd., Republic of Korea) in which the light-emitting areas have a diamond arrangement, or a hexagonal structure in which light-emitting areas having a hexagonal planar shape are arranged.

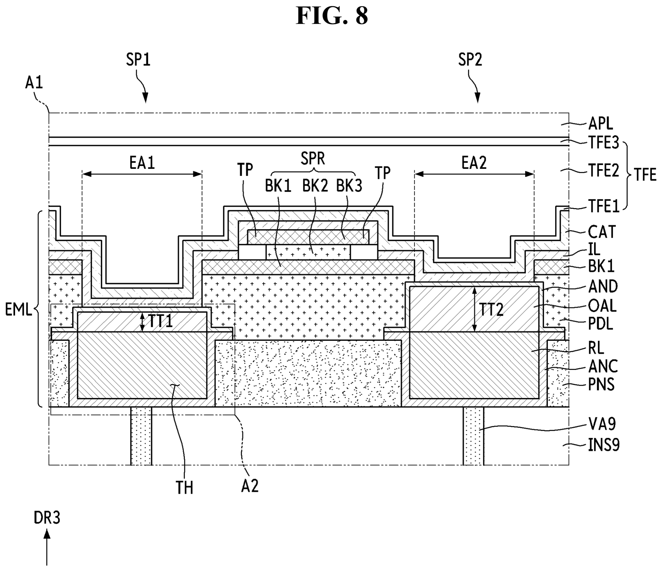

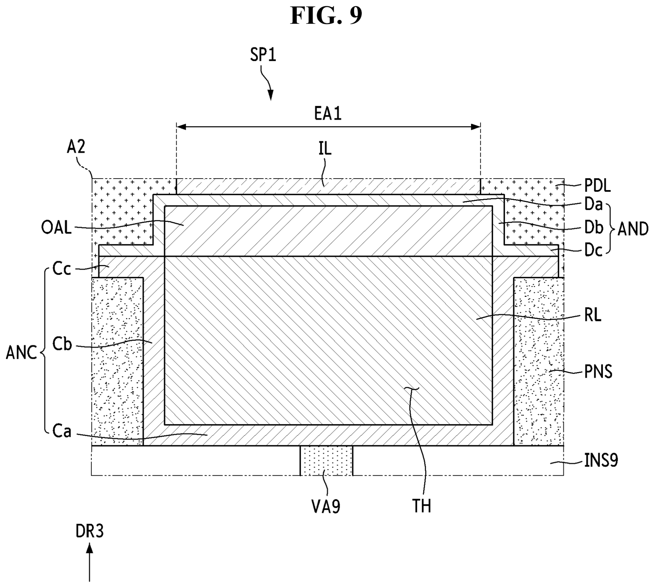

FIG. 7 is a cross-sectional view illustrating an example of the display panel taken along the line l1-l1' of FIG. 5, FIG. 8 is a cross-sectional view illustrating area A1 of FIG. 7 in detail, and FIG. 9 is a cross-sectional view illustrating area A2 of FIG. 8 in detail.

Referring to FIGS. 7 to 9, the display panel 100 includes a semiconductor backplane SBP, a light-emitting element backplane EBP, a display element layer EML, an encapsulation layer TFE, an optical layer OPL, a cover layer CVL, and a polarizing plate POL.

The semiconductor backplane SBP includes a semiconductor substrate SSUB including a plurality of pixel transistors PTR, a plurality of semiconductor insulating layers covering the plurality of pixel transistors PTR, and a plurality of contact terminals CTE electrically connected to the plurality of pixel transistors PTR, respectively. The plurality of pixel transistors PTR may be the first to sixth transistors T1 to T6 described with reference to FIG. 4.

The semiconductor substrate SSUB may be a silicon substrate, a germanium substrate, or a silicon-germanium substrate. The semiconductor substrate SSUB may be a substrate doped with first-type impurities. A plurality of well areas WA may be located in an upper surface of the semiconductor substrate SSUB. The plurality of well areas WA may be areas doped with second-type impurities. The second-type impurity may be different from the first-type impurity described above. For example, when the first-type impurity is a p-type impurity, the second-type impurity may be an n-type impurity. Alternatively, when the first-type impurity is an n-type impurity, the second-type impurity may be a p-type impurity.

Each of the plurality of well areas WA includes a source area SA corresponding to a source electrode of the pixel transistor PTR, a drain area DA corresponding to a drain electrode thereof, and a channel area CH located between the source area SA and the drain area DA.

A lower insulating layer BINS may be located between the gate electrode GE and the well area WA. A side insulating layer SINS may be located on a side surface of the gate electrode GE. The side insulating layer SINS may be located on the lower insulating layer BINS.

Each of the source area SA and the drain area DA may be an area doped with first-type impurities. The gate electrode GE of the pixel transistor PTR may overlap the well area WA in the third direction DR3, which is a thickness direction of the semiconductor substrate SSUB. The channel area CH may overlap the gate electrode GE in the third direction DR3. The source area SA may be located on one side of the gate electrode GE, and the drain area DA may be located on the other side of the gate electrode GE.

Each of the plurality of well areas WA further includes a first low-concentration impurity area LDD1 located between the channel area CH and the source area SA, and a second low-concentration impurity area LDD2 located between the channel area CH and the drain area DA. The first low-concentration impurity area LDD1 may be an area having an impurity concentration lower than that of the source area SA due to the lower insulating layer BINS. The second low-concentration impurity area LDD2 may be an area having an impurity concentration lower than that of the drain area DA due to the lower insulating layer BINS. A distance between the source area SA and the drain area DA may be increased due to the first low-concentration impurity area LDD1 and the second low-concentration impurity area LDD2. Therefore, because a length of the channel area CH of each of the pixel transistors PTR may increase, punch-through and hot carrier phenomena caused by a short channel may be reduced or prevented.

A first semiconductor insulating layer SINS1 may be located on the semiconductor substrate SSUB. The first semiconductor insulating layer SINS1 may include a silicon carbon nitride (SiCN) or silicon oxide (SiOₓ)-based inorganic film, but the present disclosure is not limited thereto.

A second semiconductor insulating layer SINS2 may be located on the first semiconductor insulating layer SINS1. The second semiconductor insulating layer SINS2 may include a silicon oxide (SiOₓ)-based inorganic film, but the present disclosure is not limited thereto.

A plurality of contact terminals CTE may be located on the second semiconductor insulating layer SINS2. Each of the plurality of contact terminals CTE may be connected to any one of the gate electrode GE, the source area SA, or the drain area DA of each of the pixel transistors PTR through a hole penetrating through the first semiconductor insulating layer SINS1 and the second semiconductor insulating layer SINS2. The plurality of contact terminals CTE may include any one of copper (Cu), aluminium (Al), tungsten (W), molybdenum (Mo), chromium (Cr), gold (Au), titanium (Ti), nickel (Ni), or neodymium (Nd), or an alloy including any one thereof.

A third semiconductor insulating layer SINS3 may be located on a side surface of each of the plurality of contact terminals CTE. An upper surface of each of the plurality of contact terminals CTE may be exposed without being covered by the third semiconductor insulating layer SINS3. The third semiconductor insulating layer SINS3 may include a silicon oxide (SiOₓ)-based inorganic film, but the present disclosure is not limited thereto.

In one or more embodiments, the semiconductor substrate SSUB may include a glass substrate or a polymer resin substrate, such as polyimide. In this case, thin film transistors may be located on the glass substrate or the polymer resin substrate. The glass substrate may be a rigid substrate that is not bent, and the polymer resin substrate may be a flexible substrate that may be bent or curved.

The light-emitting element backplane EBP includes a plurality of conductive layers ML1 to ML8, a plurality of via electrodes VA1 to VA9, and a plurality of insulating layers INS1 to INS11. In addition, the light-emitting element backplane EBP includes a plurality of insulating layers INS1 to INS9 located between first to eighth conductive layers ML1 to ML8.

The first to eighth conductive layers ML1 to ML8 serve to implement the circuit of the first sub-pixel SP1 illustrated in FIG. 4 by connecting the plurality of contact terminals CTE exposed from the semiconductor backplane SBP. For example, only the first to sixth transistors T1 to T6 are formed in the semiconductor backplane SBP, and the first to sixth transistors T1 to T6 and the first and second capacitors CP1 and CP2 are connected through the first to eighth conductive layers ML1 to ML8. In addition, the drain area corresponding to the drain electrode of the fourth transistor T4, the source area corresponding to the source electrode of the fifth transistor T5, and the first electrode AND of the light-emitting element LE are also connected through the first to eighth conductive layers ML1 to ML8.

A first insulating layer INS1 may be located on the semiconductor backplane SBP. Each first via electrode VA1 may penetrate through the first insulating layer INS1 and be connected to the contact terminal CTE exposed from the semiconductor backplane SBP. Each of the first conductive layers ML1 may be located on the first insulating layer INS1 and may be connected to the first via electrode VA1.

A second insulating layer INS2 may be located on the first insulating layer INS1 and the first conductive layers ML1. Each second via electrode VA2 may be connected to the first conductive layer ML1 exposed by penetrating through the second insulating layer INS2. Each of the second conductive layers ML2 may be located on the second insulating layer INS2 and may be connected to the second via electrode VA2.

A third insulating layer INS3 may be located on the second insulating layer INS2 and the second conductive layers ML2. Each third via electrode VA3 may be connected to the second conductive layer ML2 exposed by penetrating through the third insulating layer INS3. Each of the third conductive layers ML3 may be located on the third insulating layer INS3 and may be connected to the third via electrode VA3.

A fourth insulating layer INS4 may be located on the third insulating layer INS3 and the third conductive layer ML3. Each fourth via electrode VA4 may be connected to the third conductive layer ML3 exposed by penetrating through the fourth insulating layer INS4. Each of the fourth conductive layers ML4 may be located on the fourth insulating layer INS4 and may be connected to the fourth via electrode VA4.

A fifth insulating layer INS5 may be located on the fourth insulating layer INS4 and the fourth conductive layers ML4. Each fifth via electrode VA5 may be connected to the fourth conductive layer ML4 exposed by penetrating through the fifth insulating layer INS5. Each of the fifth conductive layers ML5 may be located on the fifth insulating layer INS5 and may be connected to the fifth via electrode VA5.

A sixth insulating layer INS6 may be located on the fifth insulating layer INS5 and the fifth conductive layers ML5. Each sixth via electrode VA6 may be connected to the fifth conductive layer ML5 exposed by penetrating through the sixth insulating layer INS6. Each of the sixth conductive layers ML6 may be located on the sixth insulating layer INS6 and may be connected to the sixth via electrode VA6.

A seventh insulating layer INS7 may be located on the sixth insulating layer INS6 and the sixth conductive layers ML6. Each seventh via electrode VA7 may be connected to the sixth conductive layer ML6 exposed by penetrating through the seventh insulating layer INS7. Each of the seventh conductive layers ML7 may be located on the seventh insulating layer INS7 and may be connected to the seventh via electrode VA7.

An eighth insulating layer INS8 may be located on the seventh insulating layer INS7 and the seventh conductive layers ML7. Each eighth via electrode VA8 may be connected to the seventh conductive layer ML7 exposed by penetrating through the eighth insulating layer INS8. Each of the eighth conductive layers ML8 may be located on the eighth insulating layer INS8 and may be connected to the eighth via electrode VA8.

The first to eighth conductive layers ML1 to ML8 and the first to eighth via electrodes VA1 to VA8 may include substantially the same material. The first to eighth conductive layers ML1 to ML8 and the first to eighth via electrodes VA1 to VA8 may include any one of copper (Cu), aluminium (Al), tungsten (W), molybdenum (Mo), chromium (Cr), gold (Au), titanium (Ti), nickel (Ni), or neodymium (Nd), or an alloy including any one thereof. The first to eighth via electrodes VA1 to VA8 may include substantially the same material. The first to eighth insulating layers INS1 to INS8 may include a silicon oxide (SiOₓ)-based inorganic film, but the present disclosure is not limited thereto.

Each of a thickness of the first conductive layer ML1, a thickness of the second conductive layer ML2, a thickness of the third conductive layer ML3, a thickness of the fourth conductive layer ML4, a thickness of the fifth conductive layer ML5, and a thickness of the sixth conductive layer ML6 may be greater than each of a thickness of the first via electrode VA1, a thickness of the second via electrode VA2, a thickness of the third via electrode VA3, a thickness of the fourth via electrode VA4, a thickness of the fifth via electrode VA5, and a thickness of the sixth via electrode VA6. Each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same. For example, the thickness of the first conductive layer ML1 may be approximately 1,360 Å, each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be approximately 1,440 Å, and each of the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6 may be approximately 1,150 Å.

Each of a thickness of the seventh conductive layer ML7 and a thickness of the eighth conductive layer ML8 may be greater than each of the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. Each of the thickness of the seventh conductive layer ML7 and the thickness of the eighth conductive layer ML8 may be greater than each of a thickness of the seventh via electrode VA7 and a thickness of the eighth via electrode VA8. Each of the thickness of the seventh via electrode VA7 and the thickness of the eighth via electrode VA8 may be greater than each of the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6. The thickness of the seventh conductive layer ML7 and the thickness of the eighth conductive layer ML8 may be substantially the same. For example, each of the thickness of the seventh conductive layer ML7 and the thickness of the eighth conductive layer ML8 may be approximately 9,000 Å. Each of the thicknesses of the seventh via electrode VA7 and the eighth via electrode VA8 may be approximately 6,000 Å.

A ninth insulating layer INS9 may be located on the eighth insulating layer INS8 and the eighth conductive layer ML8. The ninth insulating layer INS9 may include a silicon oxide (SiOₓ)-based inorganic film, but the present disclosure is not limited thereto.

Each ninth via electrode VA9 may be connected to the eighth conductive layer ML8 exposed by penetrating through the ninth insulating layer INS9. The ninth via electrodes VA9 may include any one of copper (Cu), aluminium (Al), tungsten (W), molybdenum (Mo), chromium (Cr), gold (Au), titanium (Ti), nickel (Ni), or neodymium (Nd), or an alloy including any one thereof. A thickness of the ninth via electrode VA9 may be approximately 16,500 Å.

The display element layer EML may be located on the light-emitting element backplane EBP. The display element layer EML may include a plurality of connection electrodes ANC, a plurality of reflective electrodes RL, a planarization layer PNS, a pixel-defining layer PDL, a plurality of first electrodes AND, a light-emitting stack IL, a second electrode CAT, and a separator SPR.

In addition, the display element layer EML may include a first light-emitting area EA1, a second light-emitting area EA2, and a third light-emitting area EA3. Each of the first light-emitting area EA1, the second light-emitting area EA2, and the third light-emitting area EA3 may be an area in which the first electrode AND, the light-emitting stack IL, and the second electrode CAT are sequentially stacked. Each of the first light-emitting area EA1, the second light-emitting area EA2, and the third light-emitting area EA3 may be an area in which the light-emitting element LE including the first electrode AND, the light-emitting stack IL, and the second electrode CAT is disposed. Each of the first light-emitting area EA1, the second light-emitting area EA2, and the third light-emitting area EA3 may be partitioned by the pixel-defining layer PDL.

The planarization layer PNS may be located on the ninth insulating layer INS9. The planarization layer PNS may have through holes TH that overlap the light-emitting areas EA1, EA2, and EA3, respectively. The through holes TH may overlap the ninth via electrodes VA9 and the ninth insulating layer INS9. The ninth via electrodes VA9 may be exposed through the through holes TH. In addition, a portion of the ninth insulating layer INS9 may be exposed through the through holes TH. The planarization layer PNS may include the same material as the ninth insulating layer INS9. In this case, the planarization layer PNS and the ninth insulating layer INS9 may be integrally formed without an interface. When the planarization layer PNS and the ninth insulating layer INS9 are integrally formed in this way, the structure including the planarization layer PNS and the ninth insulating layer INS9 may have a trench instead of the through hole TH. For example, the through hole TH in the planarization layer PNS may be a trench in the structure.

The plurality of connection electrodes ANC may be located on the ninth via electrodes VA9, the ninth insulating layer INS9, and the planarization layer PNS. For example, the plurality of connection electrodes ANC may be located on the ninth insulating layer INS9 and the planarization layer PNS so as to be respectively connected to the plurality of ninth via electrodes VA9. In this case, the connection electrodes ANC may be located along an inner wall of the through hole TH and an upper surface of the ninth insulating layer INS9 within the through hole TH. The plurality of connection electrodes ANC may include titanium nitride (TiN) or a transparent conductive oxide. For example, the transparent conductive oxide may be Indium Tin Oxide (ITO) or Indium Zinc Oxide (IZO), but the present disclosure is not limited thereto.

As illustrated in FIG. 9, the connection electrode ANC may include a lower electrode Ca, a side electrode Cb, and an upper electrode Cc formed integrally with each other.

The lower electrode Ca of the connection electrode ANC may be located on the ninth via electrode VA9 and the ninth insulating layer INS9 within the through hole TH of the planarization layer PNS (as used herein, "located on" may mean "above"). The lower electrode Ca of the connection electrode ANC may be in contact (or direct contact) with the ninth via electrode VA9 and the ninth insulating layer INS9 within the through hole TH of the planarization layer PNS.

The side electrode Cb of the connection electrode ANC may be located on the inner wall of the through hole TH within the through hole TH of the planarization layer PNS. The side electrode Cb of the connection electrode ANC may be located at an edge of the lower electrode Ca within the through hole TH. The side electrode Cb of the connection electrode ANC may be connected to the edge of the lower electrode Ca.

The upper electrode Cc of the connection electrode ANC may be located outside the through hole TH of the planarization layer PNS. For example, the upper electrode Cc of the connection electrode ANC may be located on an upper surface of the planarization layer PNS. The upper electrode Cc of the connection electrode ANC may be connected to the side electrode Cb. For example, one side (or one end) of the side electrode Cb may be connected to the lower electrode Ca, and the other side (or the other end) of the side electrode Cb may be connected to the upper electrode Cc. Because an edge of the connection electrode ANC may contact an edge of the first electrode AND, the edge of the connection electrode ANC may include the upper electrode Cc of the connection electrode ANC (e.g., the upper electrode Cc, or an edge thereof, may contact an edge of the first electrode AND).

The connection electrode ANC including the upper electrode Cc, the side electrode Cb, and the lower electrode Ca may have a U-shaped cross-section.

The plurality of reflective electrodes RL may be respectively located on the plurality of connection electrodes ANC. For example, the reflective electrodes RL may each be located within the through holes TH of the ninth insulating layer INS9. In this case, the reflective electrode RL may be connected to the connection electrode ANC. For example, within the through hole TH, the reflective electrode RL may be in contact (or in direct contact) with the connection electrode ANC. A height of an upper surface of the reflective electrode RL may be the same as a height of an upper surface of the connection electrode ANC (e.g., the same as an upper surface of the connection electrode ANC located on the planarization layer PNS, or an upper surface of the upper electrode of the connection electrode ANC). The reflective electrode RL may be surrounded in a U-shape by the connection electrode ANC within the through hole TH. For example, a lower surface and a side surface of the reflective electrode RL excluding the upper surface of the reflective electrode RL may each be covered by the connection electrode ANC. In other words, the lower surface of the reflective electrode RL may be covered by the lower electrode Ca of the connection electrode ANC, and the side surface of the reflective electrode RL may be covered by the side electrode Cb of the connection electrode ANC. Each reflective electrode RL may include any one of copper (Cu), aluminium (Al), silver (Ag), tungsten (W), molybdenum (Mo), chromium (Cr), gold (Au), titanium (Ti), nickel (Ni), or neodymium (Nd), or an alloy including any one thereof. For example, each reflective electrode RL may include aluminium (Al) or silver (Ag).

Optical auxiliary layers OAL may be respectively located on the reflective electrodes RL. For example, the optical auxiliary layer OAL may be located on the upper surface of the reflective electrode RL. The optical auxiliary layer OAL may contact (or directly contact) the upper surface of the reflective electrode RL. The optical auxiliary layer OAL together with the connection electrode ANC may completely surround the reflective electrode RL. For example, from a cross-sectional perspective, the reflective electrode RL may be surrounded by the optical auxiliary layer OAL and the connection electrode ANC. The optical auxiliary layer OAL may include a silicon oxide (SiOₓ)-based inorganic film, but the present disclosure is not limited thereto.

The optical auxiliary layer OAL may serve as a resonant film that increases light efficiency by differentiating a resonance distance between the respective sub-pixels SP1, SP2, and SP3. To this end, according to one or more embodiments, the first sub-pixel and the second sub-pixel may include optical auxiliary layers OAL of different respective thicknesses.

For example, referring to FIG. 8, a thickness TT1 of the optical auxiliary layer OAL in the first sub-pixel SP1, and a thickness TT2 of the optical auxiliary layer OAL in the second sub-pixel SP2, may be different. For example, the thickness TT2 of the optical auxiliary layer OAL in the second sub-pixel SP2 may be greater than the thickness TT1 of the optical auxiliary layer OAL in the first sub-pixel SP1. For example, the thickness of the optical auxiliary layer OAL may be different for each sub-pixel SP1 to SP3.

A thickness of the optical auxiliary layer OAL in the third sub-pixel SP3 may be the same as the thickness TT2 of the optical auxiliary layer OAL in the second sub-pixel SP2. However, the present disclosure is not limited thereto, and the thickness of the optical auxiliary layer OAL in the third sub-pixel SP3 may be greater than the thickness TT2 of the optical auxiliary layer OAL in the second sub-pixel SP2.

The thickness TT1 of the optical auxiliary layer OAL in the first sub-pixel SP1, the thickness TT2 of the optical auxiliary layer OAL in the second sub-pixel SP2, and the thickness of the optical auxiliary layer OAL in the third sub-pixel SP3 may be set by considering a main peak wavelength of first light, a main peak wavelength of second light, a main peak wavelength of third light, a distance from the first stack layer of the light-emitting stack IL to the reflective electrode RL in the first light-emitting area EA1, a distance from the second stack layer of the light-emitting stack IL to the reflective electrode RL in the second light-emitting area EA2, and/or a distance from the third stack layer of the light-emitting stack IL to the reflective electrode RL in the third light-emitting area EA3, and accordingly, a resonance distance of the first light, a resonance distance of the second light, and a resonance distance of the third light may be set.

Each light-emitting element LE may include a first electrode AND, a light-emitting stack IL, and a second electrode CAT.

The first electrode AND may be located on the optical auxiliary layer OAL. For example, the first electrode AND may be located on the upper surface of the optical auxiliary layer OAL, on the side surface of the optical auxiliary layer OAL, and on the upper surface of the connection electrode ANC (e.g., on the upper surface of the upper electrode Cc of the connection electrode ANC). The first electrode AND may contact (or may be in direct contact with) the upper surface of the optical auxiliary layer OAL, the side surface of the optical auxiliary layer OAL, and the upper surface of the connection electrode ANC (e.g., the upper surface of the upper electrode Cc of the connection electrode ANC). As the first electrode AND and the connection electrode ANC contact each other, the first electrode AND and the connection electrode ANC may be electrically connected to each other. The first electrode AND may surround the optical auxiliary layer OAL together with the reflective electrode RL described above.

An edge of the first electrode AND and an edge of the connection electrode ANC may face each other. The edge of the first electrode AND and the edge of the connection electrode ANC may contact each other without a step. The edge of the first electrode AND may be located on the edge of the connection electrode ANC.

As illustrated in FIG. 9, the first electrode AND may include a lower electrode Dc, a side electrode Db, and an upper electrode Da formed integrally with each other.

The lower electrode Dc of the first electrode AND may be located on the connection electrode ANC. For example, the lower electrode Dc of the first electrode AND may be located on the upper electrode Cc of the connection electrode ANC. The lower electrode Dc of the first electrode AND and the upper electrode Cc of the connection electrode ANC may be electrically connected to each other. The lower electrode Dc of the first electrode AND and the upper electrode Cc of the connection electrode ANC may contact (or in may be direct contact with) each other.

The side electrode Db of the first electrode AND may be located on the side surface of the optical auxiliary layer OAL. The side electrode Db of the first electrode AND may contact (or may be in direct contact with) the side surface of the optical auxiliary layer OAL. The side electrode Db of the first electrode AND may be connected to the lower electrode Dc of the first electrode AND. In addition, the side electrode Db of the first electrode AND may be connected to the upper electrode Cc of the connection electrode ANC and the side electrode Cb of the connection electrode ANC.

The upper electrode Da of the first electrode AND may be located on the upper surface of the optical auxiliary layer OAL. The upper electrode Da of the first electrode AND may be connected to the side electrode Db of the first electrode AND. For example, one side (or one end) of the side electrode Db of the first electrode AND may be connected to the lower electrode Dc of the first electrode AND, and the other side (or other end) of the side electrode Db of the first electrode AND may be connected to the upper electrode Da of the first electrode AND. The edge of the first electrode AND may include the lower electrode Dc of the first electrode AND. The lower electrode Dc of the first electrode AND and the upper electrode Cc of the connection electrode ANC may contact each other without a step.

The first electrode AND including the upper electrode Da and the side electrode Db may have an inverted U-shaped cross-section. For example, the first electrode AND may have a shape that is inverted with respect to the connection electrode ANC.

A thickness of the first electrode AND on the side surface of the optical auxiliary layer OAL (e.g., a thickness of the side electrode Db of the first electrode AND) may be different from a thickness of the first electrode AND on the upper surface of the optical auxiliary layer OAL (e.g., a thickness of the upper electrode Da of the first electrode AND). For example, the thickness of the first electrode AND on the side surface of the optical auxiliary layer OAL may be less than the thickness of the first electrode AND on the upper surface of the optical auxiliary layer OAL.

According to one or more embodiments, the first electrode AND may be electrically connected to the reflective electrode RL through the connection electrode ANC. In this case, as the lower electrode Dc of the first electrode AND contacts the upper electrode Cc of the connection electrode ANC, the first electrode AND and the connection electrode ANC may be electrically connected to each other. For example, because the first electrode AND contacts only the upper surface of the connection electrode ANC, the first electrode AND may contact the connection electrode ANC while being bent only once by the optical auxiliary layer OAL. In other words, the lower electrode Dc of the first electrode AND may contact the upper electrode Cc of the connection electrode ANC without bending (or step). Therefore, the possibility of damage (e.g., short circuit) to the first electrode AND may be reduced or minimized.

When an interface between the lower electrode Dc of the first electrode AND and the upper electrode Cc of the connection electrode ANC is defined as a first interface, and an interface between the optical auxiliary layer OAL and the reflective electrode RL is defined as a second interface, the first interface and the second interface may overlap in a horizontal direction. In addition, the first interface and the second interface may extend along an imaginary straight line. In addition, the first interface and the second interface may be aligned with each other.

The first electrode AND of each of the light-emitting elements LE may be connected to the drain area DA or the source area SA of the pixel transistor PTR through the connection electrode ANC, the first to ninth via electrodes VA1 to VA9, the first to eighth conductive layers ML1 to ML8, and the contact terminal CTE.

The first electrode AND of each of the light-emitting elements LE may include any one of copper (Cu), aluminium (Al), tungsten (W), molybdenum (Mo), chromium (Cr), gold (Au), titanium (Ti), nickel (Ni), or neodymium (Nd), or an alloy including any one thereof. For example, the first electrode AND of each of the light-emitting elements LE may include titanium nitride (TiN).

The pixel-defining layer PDL may partition the first light-emitting areas EA1, the second light-emitting areas EA2, and the third light-emitting areas EA3. The pixel-defining layer PDL may be located on a partial area of the first electrode AND of each of the light-emitting elements LE. The pixel-defining layer PDL may cover the edge of the first electrode AND of each of the light-emitting elements LE. The pixel-defining layer PDL may contact (or may be in direct contact with) the first electrode AND. The pixel-defining layer PDL may be located on the first electrode AND. For example, the pixel-defining layer PDL may be located on the upper surface of the first electrode AND (e.g., a portion(s) of the upper surface of the first electrode AND) and on the side surface of the first electrode AND. The first pixel-defining layer PDL1 may be made of a material including silicon nitride (SiNx).

The first light-emitting area EA1 may be defined as an area in which the first electrode AND, the light-emitting stack IL, and the second electrode CAT are sequentially stacked in the first sub-pixel SP1 to emit light. The second light-emitting area EA2 may be defined as an area in which the first electrode AND, the light-emitting stack IL, and the second electrode CAT are sequentially stacked in the second sub-pixel SP2 to emit light. The third light-emitting area EA3 may be defined as an area in which the first electrode AND, the light-emitting stack IL, and the second electrode CAT are sequentially stacked in the third sub-pixel SP3 to emit light.

The separator SPR may be located on the pixel-defining layer PDL. In plan view, as illustrated in FIGS. 5 and 6, the separator SPR may have a shape surrounding each of the light-emitting areas EA1, EA2, and EA3. The separator SPR may be located on the pixel-defining layer PDL to surround each of the light-emitting areas EA1, EA2, and EA3. The separator SPR may be a structure for cutting the light-emitting stack IL. To this end, according to one or more embodiments, the separator SPR may include a first bank BK1, a second bank BK2, and a third bank BK3 having different areas.

The first bank BK1 may be located on the pixel-defining layer PDL. The first bank BK1 may be made of a material including silicon oxide (SiOx).

The second bank BK2 may be located on the first bank BK1. The second bank BK2 may be located on the first bank BK1 to overlap the first bank BK1. In this case, an area of the second bank BK2 may be smaller than an area of the first bank BK1. For example, the area of the second bank BK2 may be smaller than the area of the first bank BK1 so that the second bank BK2 may be surrounded by an edge of the first bank BK1 (e.g., in plan view). An etching rate of the second bank BK2 may be different from an etching rate of the first bank BK1. For example, the etching rate of the second bank BK2 may be greater than the etching rate of the first bank BK1. The second bank BK2 may be made of a material including silicon nitride (SiNx). Unlike this, the second bank BK2 may be made of a material including metal. For example, the second bank may be made of a material including at least one of titanium (Ti), tantalum (Ta), or molybdenum (Mo).

The third bank BK3 may be located on the second bank BK2. The third bank BK3 may be located on the second bank BK2 to overlap the second bank BK2. In this case, an area of the third bank BK3 may be greater than the area of the second bank BK2. For example, in plan view, the area of the third bank BK3 may be greater than the area of the second bank BK2 so that the third bank BK3 may surround an edge of the second bank BK2. Accordingly, as illustrated in FIG. 9, the third bank BK3 may include a tip TP that does not overlap the second bank BK2. The etching rate of the second bank BK2 may be different from an etching rate of the third bank BK3. For example, the etching rate of the second bank BK2 may be greater than the etching rate of the third bank BK3. The third bank BK3 may be made of a material including silicon oxide (SiOx).

The separator SPR including the first bank BK1, the second bank BK2, and the third bank BK3 may have a central width that is less than the upper and lower widths in a cross-sectional view.

The light-emitting stack IL may be located on the first electrodes AND and the separator SPR. For example, the light-emitting stack may be located on the first bank BK1 and the third bank BK3 of the separator SPR. In this case, the light-emitting stack IL may be cut on the separators SPR. For example, the light-emitting stack IL may be cut between the first bank BK1 and the third bank BK3. In plan view, the light-emitting stack IL may be cut along the separator SPR. Therefore, the light-emitting stack IL may be divided into a portion contacting the first electrode AND in the light-emitting area, and a portion located on an area excluding the light-emitting area (e.g., the third bank BK3 of the separator SPR). In other words, the light-emitting stack IL may be cut along the separator SPR to be separated for each sub-pixel. Accordingly, lateral leakage current between the sub-pixels SP1, SP2, and SP3 adjacent to each other may be reduced or minimized. As this lateral leakage current is reduced or minimized, color mixing between the sub-pixels SP1, SP2, and SP3 adjacent to each other may be reduced or prevented, thereby improving an image quality of the display device 10.

The light-emitting stack IL may include a plurality of stack layers sequentially stacked along the third direction DR3. For example, the light-emitting stack IL may have a three-tandem structure including a first stack layer, a second stack layer on the first stack layer, and a third stack layer on the second stack layer. Here, the second stack layer may be located between the first stack layer and the third stack layer. However, the present disclosure is not limited thereto. For example, the light-emitting stack IL may also have a two-tandem structure including two stack layers.

In the three-tandem structure, the first stack layer, the second stack layer, and the third stack layer of the light-emitting stack IL may provide light of different respective colors (or wavelengths). For example, one of the first stack layer, the second stack layer, or the third stack layer may provide light of a first color (e.g., green), another of the first stack layer, the second stack layer, and the third stack layer may provide light of a second color (e.g., red), and the other of the first stack layer, the second stack layer, and the third stack layer may provide light of a third color (e.g., blue).

The first stack layer of the light-emitting stack IL may have a structure in which a first hole-transporting layer, a first organic light-emitting layer, and a first electron-transporting layer are sequentially stacked. The second stack layer of the light-emitting stack IL may have a structure in which a second hole-transporting layer, a second organic light-emitting layer, and a second electron-transporting layer are sequentially stacked. The third stack layer of the light-emitting stack IL may have a structure in which a third hole-transporting layer, a third organic light-emitting layer, and a third electron-transporting layer are sequentially stacked. Here, the first organic light-emitting layer, the second organic light-emitting layer, and the third organic light-emitting layer may provide light of different colors (or wavelengths). For example, one of the first organic light-emitting layer, the second organic light-emitting layer, or the third organic light-emitting layer may provide light of a first color (e.g., green), another of the first organic light-emitting layer, the second organic light-emitting layer, and the third organic light-emitting layer may provide light of a second color (e.g., red), and the other of the first organic light-emitting layer, the second organic light-emitting layer, and the third organic light-emitting layer may provide light of a third color (e.g., blue).

A first charge-generating layer for supplying charges to the second stack layer and supplying electrons to the first stack layer may be located between the first stack layer and the second stack layer. The first charge-generating layer may include an n-type charge-generating layer that supplies electrons to the first stack layer and a p-type charge-generating layer that supplies holes to the second stack layer. The n-type charge-generating layer may include a dopant of a metallic material.

A second charge-generating layer for supplying charges to the third stack layer and supplying electrons to the second stack layer may be located between the second stack layer and the third stack layer. The second charge-generating layer may include an n-type charge-generating layer that supplies electrons to the second stack layer and a p-type charge-generating layer that supplies holes to the third stack layer.

The first stack layer of the light-emitting stack IL may be located on the first electrodes AND and the separator SPR. By means of the separator SPR described above, the first stack layer of the light-emitting stack IL may be disconnected between the sub-pixels SP1, SP2, and SP3 adjacent to each other. The second stack layer of the light-emitting stack IL may be located on the first stack layer. By means of the separator SPR described above, the second stack layer IL2 may be disconnected between the sub-pixels SP1, SP2, and SP3 adjacent to each other. The third stack layer of the light-emitting stack IL may be located on the second stack layer. The third stack layer of the light-emitting stack IL may not be separated by the separator SPR and may be located to cover the second stack layer.

In the three-tandem structure, the separator SPR may be a structure for disconnecting the first charge-generating layer and the second charge-generating layer of the display element layer EML between the sub-pixels SP1, SP2, and SP3 adjacent to each other. In addition, in the two-tandem structure, the separator SPR may be a structure for disconnecting a charge-generating layer located between a lower stack layer and an upper stack layer.

The second electrode CAT may be located on the light-emitting stack IL. For example, the second electrode CAT may be located on the third stack layer of the light-emitting stack IL. The second electrode CAT may not be disconnected by the separator SPR, and may be located on the third stack layer of the light-emitting stack IL. The second electrode CAT may include a semi-transmissive conductive material, such as magnesium (Mg), silver (Ag), or an alloy of magnesium (Mg) and silver (Ag). In this case, light emission efficiency may be increased in each of the first to third sub-pixels SP1, SP2, and SP3 by micro cavities.

The encapsulation layer TFE may be located on the display element layer EML. The encapsulation layer TFE may include one or more inorganic films TFE1 and TFE3 to reduce or prevent oxygen or moisture from permeating into the display element layer EML. For example, the encapsulation layer TFE may include a first encapsulation inorganic film TFE1, an encapsulation organic film TFE2, and a second encapsulation inorganic film TFE3.

The first encapsulation inorganic film TFE1 may be located on the second electrode CAT. The first encapsulation inorganic film TFE1 may be formed as a multi-film in which one or more inorganic films of silicon nitride (SiNₓ), silicon oxide nitride (SiON), and silicon oxide (SiOₓ) are alternately stacked. The first encapsulation inorganic film TFE1 may be formed by a chemical evaporation deposition (CVD) process.

The encapsulation organic film TFE2 may be a monomer. Alternatively, the encapsulation organic film TFE2 may be an organic film made of an acrylic resin, an epoxy resin, a phenolic resin, a polyamide resin, or a polyimide resin.

The second encapsulation inorganic film TFE3 may be located on the encapsulation organic film TFE2. The second encapsulation inorganic film TFE3 may be formed as a multi-film in which one or more inorganic films of silicon nitride (SiNₓ), silicon oxide nitride (SiON), and silicon oxide (SiOₓ) are alternately stacked. The second encapsulation inorganic film TFE3 may be formed by a chemical evaporation deposition (CVD) process.

An organic film APL may be a layer for increasing an interfacial adhesion between the encapsulation layer TFE and the optical layer OPL. The organic film APL may be an organic film made of an acryl resin, an epoxy resin, a phenolic resin, a polyamide resin, a polyimide resin, or the like.

The optical layer OPL includes a plurality of color filters CF1, CF2, and CF3, a plurality of lenses LNS, and a filling layer FIL. The plurality of color filters CF1, CF2, and CF3 may include first to third color filters CF1, CF2, and CF3. The first to third color filters CF1, CF2, and CF3 may be located on the adhesive layer ADL.

The first color filter CF1 may overlap the first light-emitting area EA1 of the first sub-pixel SP1. The first color filter CF1 may transmit first light (e.g., light in a red wavelength band). Therefore, the first color filter CF1 may transmit the first light among light emitted from the light-emitting stack IL of the first light-emitting area EA1.

The second color filter CF2 may overlap the second light-emitting area EA2 of the second sub-pixel SP2. The second color filter CF2 may transmit second light (e.g., light in a green wavelength band). Therefore, the second color filter CF2 may transmit the second light among light emitted from the light-emitting stack IL of the second light-emitting area EA2.

The third color filter CF3 may overlap the third light-emitting area EA3 of the third sub-pixel SP3. The third color filter CF3 may transmit third light (e.g., light in a blue wavelength band). Therefore, the third color filter CF3 may transmit the third light among light emitted from the light-emitting stack IL of the third light-emitting area EA3.

Each of the plurality of lenses LNS may be located on each of the first color filter CF1, the second color filter CF2, and the third color filter CF3. Each of the plurality of lenses LNS may be a structure for increasing a ratio of light directed to the front of the display device 10. It is illustrated that each of the plurality of lenses LNS has a cross-sectional shape that is convex in the upward direction, but the present disclosure is not limited thereto.

The filling layer FIL may be located on the plurality of lenses LNS. The filling layer FIL may have a refractive index so that light travels in the third direction DR3 at an interface between the plurality of lenses LNS and the filling layer FIL. In addition, the filling layer FIL may be a planarization layer. The filling layer FIL may be an organic film made of an acryl resin, an epoxy resin, a phenolic resin, a polyamide resin, or a polyimide resin.

The cover layer CVL may be located on the filling layer FIL. The cover layer CVL may be a glass substrate or a polymer resin, such as resin. When the cover layer CVL is a glass substrate, the cover layer CVL may be attached onto the filling layer FIL. In this case, the filling layer FIL may serve to adhere the cover layer CVL. When the cover layer CVL is a glass substrate, the cover layer CVL may serve as an encapsulation substrate. When the cover layer CVL is a polymer resin, such as resin, the cover layer CVL may be directly applied on the filling layer FIL.

The polarizing plate POL may be located on one surface of the cover layer CVL. The polarizing plate POL may be a structure for reducing or preventing deterioration in visibility due to reflection of external light. The polarizing plate POL may include a linear polarizing plate and a phase retardation film. For example, the phase retardation film may be a λ/4 (quarter-wave) plate, but the present disclosure is not limited thereto. However, when the deterioration in visibility due to reflection of external light is sufficiently improved by the first to third color filters CF1, CF2, and CF3, the polarizing plate POL may also be omitted.

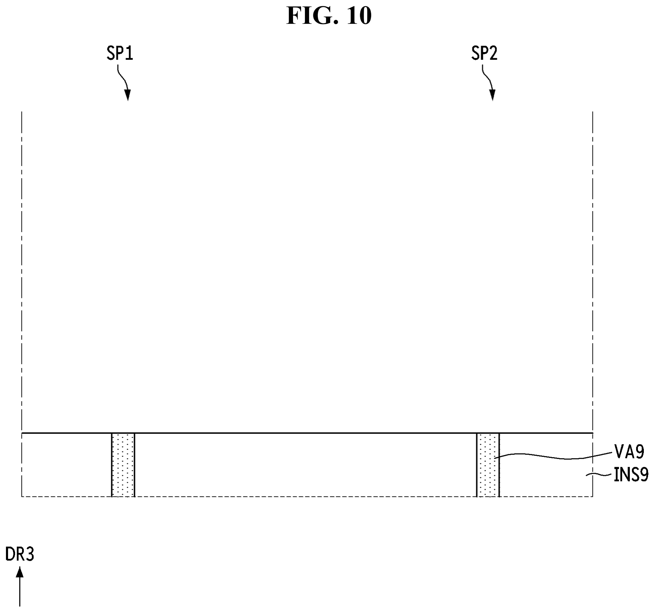

FIGS. 10, 11, 12, 13, 14, 15, 16, 17, 18, 19, 20, 21, and 22 are process diagrams for describing a method for fabricating a display device according to one or more embodiments. For example, FIGS. 10 to 22 may be process cross-sectional views for describing a method for fabricating the display device of FIG. 8 described above.

First, as illustrated in FIG. 10, a ninth insulating layer INS9 may be formed on a semiconductor substrate SSUB, and a ninth via electrode VA9 may be formed within a via hole of the ninth insulating layer INS9.

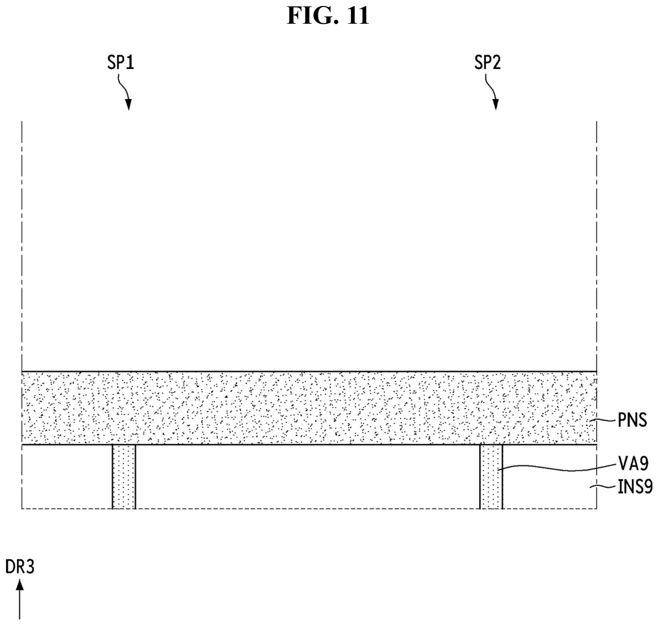

Thereafter, as illustrated in FIG. 11, a planarization layer PNS may be formed on the ninth via electrode VA9 and the ninth insulating layer INS9. For example, the planarization layer PNS may be formed on an entire surface of the semiconductor substrate SSUB including the ninth via electrode VA9 and the ninth insulating layer INS9 so as to cover the ninth via electrode VA9 and the ninth insulating layer INS9.

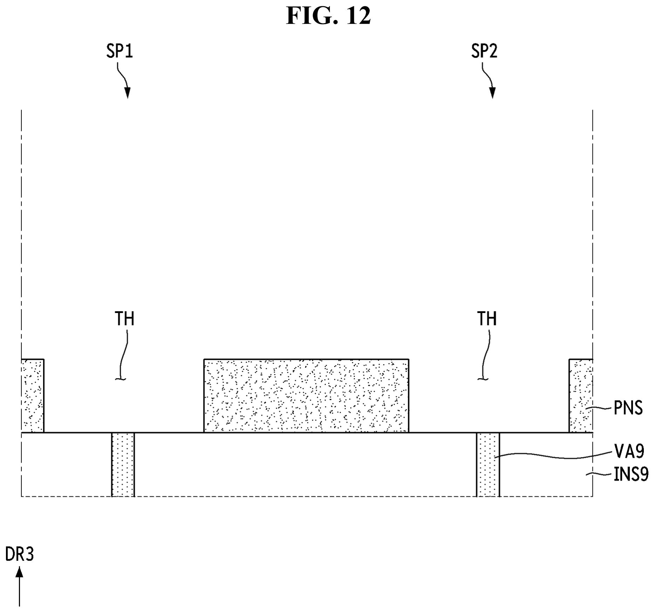

Next, as illustrated in FIG. 12, one or more through holes TH may be formed to penetrate through the planarization layer PNS and expose the ninth via electrodes VA9 and the ninth insulating layer INS9 around the ninth via electrodes VA9.

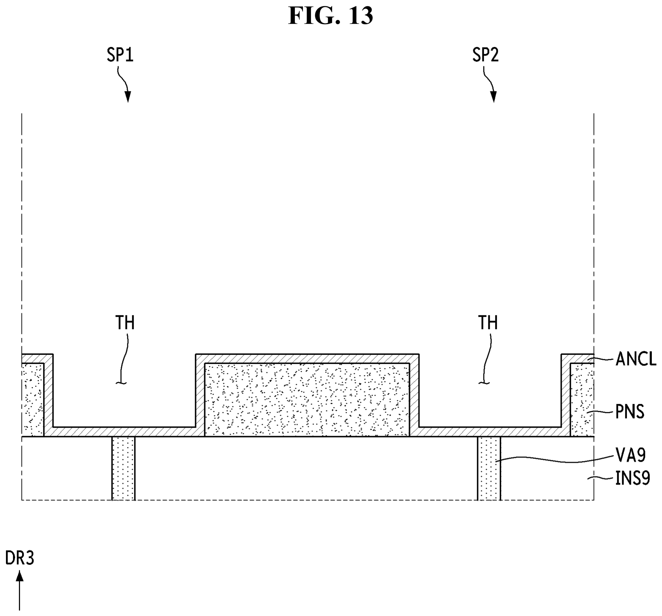

Thereafter, as illustrated in FIG. 13, a connection electrode layer ANCL may be formed on the planarization layer PNS, the ninth via electrode VA9 exposed through the through holes TH, the ninth insulating layer INS9 exposed through the through holes TH, and an inner wall of the through holes TH exposed through the through holes TH (e.g., an etched surface of the planarization layer PNS).

For example, the connection electrode layer ANCL may be formed on the entire surface of the semiconductor substrate SSUB including the planarization layer PNS, the ninth via electrode VA9 exposed through the through holes TH, the ninth insulating layer INS9 exposed through the through holes TH, and the inner wall of the through holes TH exposed through the through holes TH so as to cover the planarization layer PNS, the ninth via electrode VA9 exposed through the through holes TH, the ninth insulating layer INS9 exposed through the through holes TH, and the inner wall of the through holes TH exposed through the through holes TH. In this case, the connection electrode layer ANCL may be connected to the ninth via electrodes VA9 within the through holes TH.

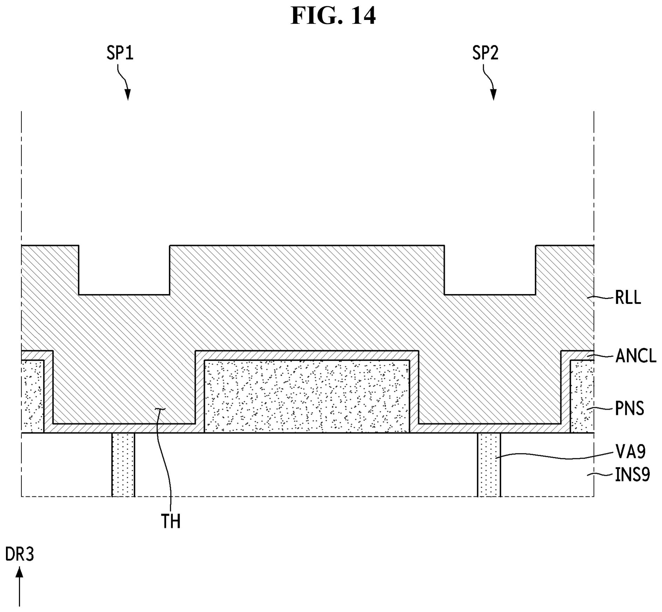

Next, as illustrated in FIG. 14, a reflective electrode layer RLL may be formed on the connection electrode layer ANCL. For example, the reflective electrode layer RLL may be formed on the entire surface of the semiconductor substrate SSUB including the reflective electrode layer RLL so as to cover the connection electrode layer ANCL. In this case, in an area overlapping the through hole TH, the reflective electrode layer RLL may have a lower height than other portions. However, the lowest portion of the reflective electrode layer RLL may be located to be at least higher than the highest portion of the connection electrode layer ANCL.

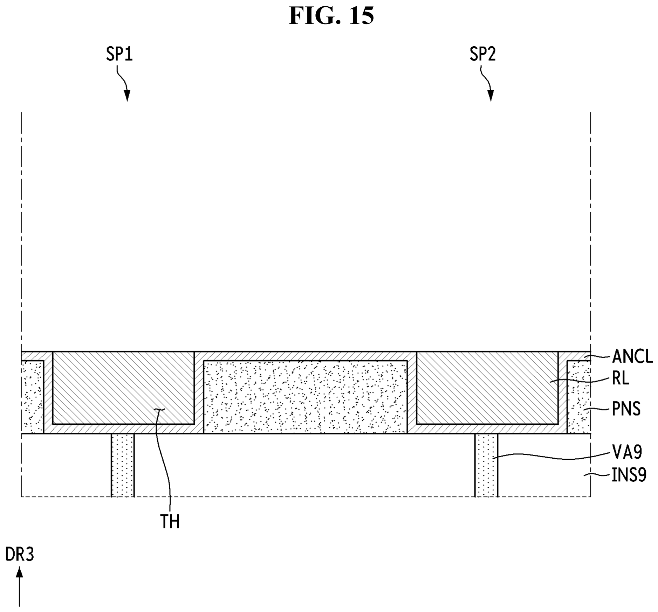

Next, as illustrated in FIG. 15, by removing a portion of the reflective electrode layer RLL on the connection electrode layer ANCL based on the connection electrode layer ANCL on the planarization layer PNS, reflective electrodes RL may be formed within the through holes TH. For example, a plurality of reflective electrodes RL may be formed by removing the reflective electrode layer RLL (e.g., the reflective electrode layer RLL outside the through holes TH) through chemical mechanical polishing. In other words, the connection electrode layer ANCL may serve as an etch stopper for the reflective electrode layer RLL during chemical mechanical polishing. The plurality of reflective electrodes RL may be selectively formed only within the through holes TH by removing the reflective electrode layer RLL until the highest portion of the connection electrode layer ANCL (e.g., the connection electrode layer ANCL on the planarization layer PNS) is exposed. An upper surface of the reflective electrode RL may be located at substantially the same height as the highest portion of the connection electrode layer ANCL.

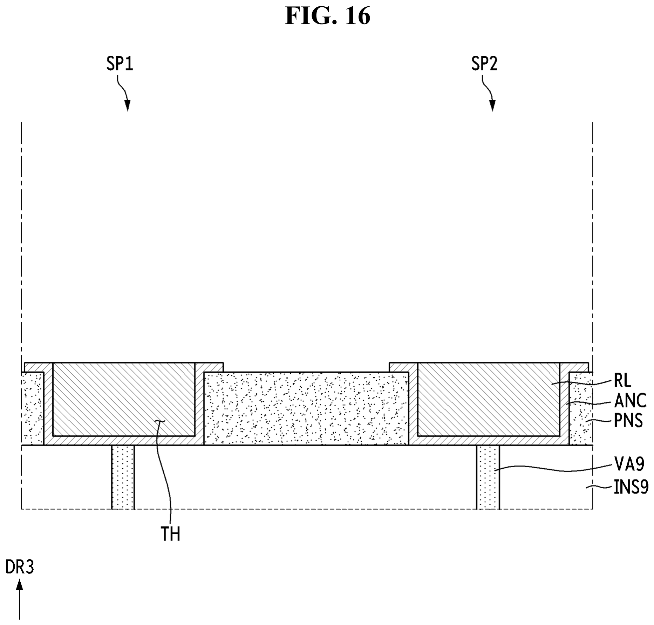

Thereafter, as illustrated in FIG. 16, a plurality of connection electrodes ANC may be formed by removing the connection electrode layer ANCL from the outside of the through hole TH (e.g., the upper surface of the planarization layer). The connection electrode ANC may cover the lower surface and the side surface of the reflective electrode RL within the through hole TH, and may be located on a portion of an upper surface of the planarization layer PNS.

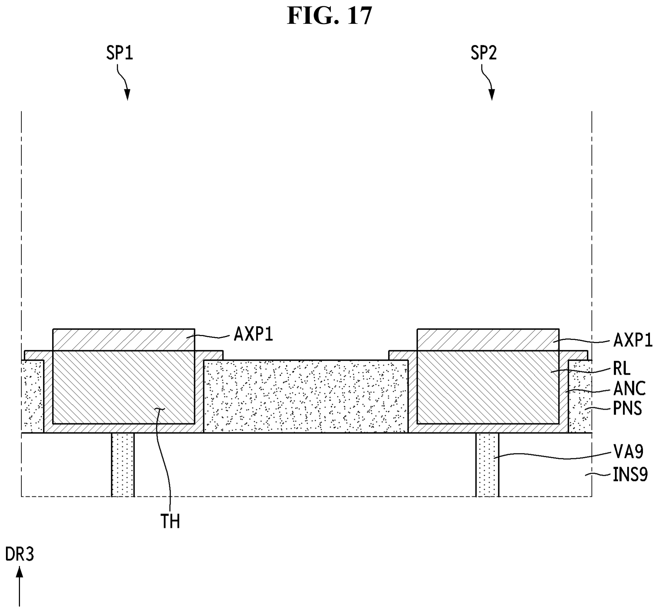

Next, as illustrated in FIG. 17, first auxiliary layers AXP1 may each be formed on the reflective electrodes RL.

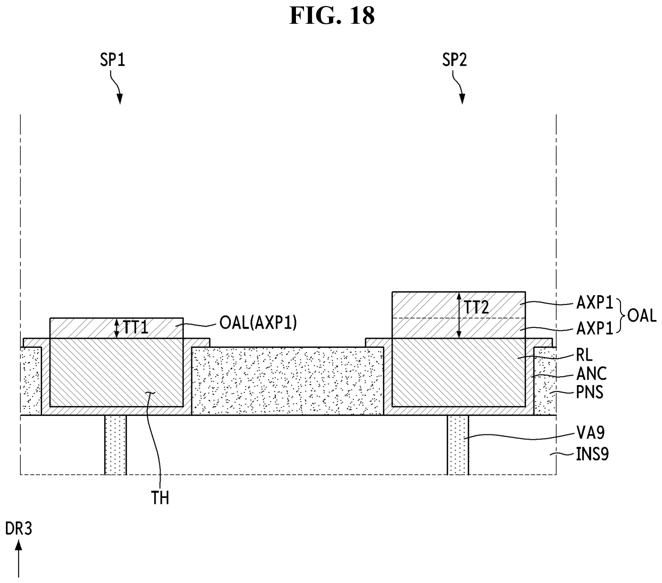

Thereafter, as illustrated in FIG. 18, second auxiliary layers AXP2 may be selectively formed on some of the first auxiliary layers AXP1. For example, the second auxiliary layer AXP2 may be formed on each of the first auxiliary layers AXP1 of the second and third sub-pixels SP2 and SP3. Accordingly, optical auxiliary layers OAL of different thicknesses may be formed in the first sub-pixel SP1 and the second sub-pixel SP2 (TT1<TT2). For example, the optical auxiliary layer OAL of the first sub-pixel SP1 may include the first auxiliary layer AXP1, while the optical auxiliary layer OAL of the second sub-pixel may include the first auxiliary layer AXP1, and the second auxiliary layer AXP2 on the first auxiliary layer AXP1. The optical auxiliary layer OAL of the third sub-pixel SP3 may also include the first auxiliary layer AXP1 and the second auxiliary layer AXP2.

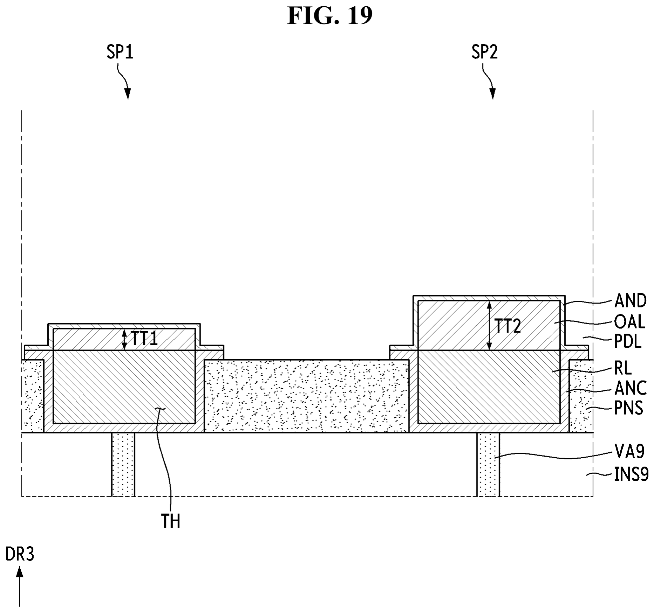

Thereafter, as illustrated in FIG. 19, first electrodes AND may each be formed on the optical auxiliary layers OAL. In this case, each edge of the first electrodes AND may contact an edge of each connection electrode ANC. For example, a lower electrode Dc of the first electrode AND may contact (or may be in direct contact with) an upper electrode Cc of the connection electrode ANC. For example, the lower electrode Dc of the first electrode AND may be connected to the upper electrode Cc of the connection electrode ANC without bending (e.g., without any step). Accordingly, the first electrode AND and the connection electrode ANC may be electrically connected while reducing or minimizing the number of bent portions of the first electrode AND. Therefore, when forming the first electrode AND, short-circuiting of the first electrode AND may be reduced or prevented.

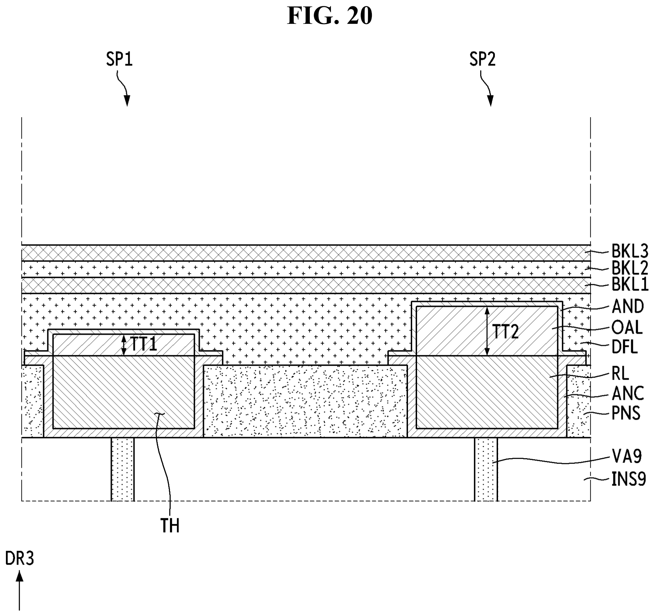

Next, as illustrated in FIG. 20, a defining layer DFL may be formed on the first electrodes AND and the planarization layer PNS, a first bank layer BKL1 may be formed on the defining layer DFL, a second bank layer BKL2 may be formed on the first bank layer BKL1, and a third bank layer BKL3 may be formed on the second bank layer BKL2. For example, the defining layer DFL may be formed on the entire surface of the semiconductor substrate SSUB including the first electrodes AND and the planarization layer PNS so as to cover the first electrodes AND and the planarization layer PNS. The first bank layer BKL1 may be formed on the entire surface of the semiconductor substrate SSUB including the defining layer DFL so as to cover the defining layer DFL. The second bank layer BKL2 may be formed on the entire surface of the semiconductor substrate SSUB including the first bank layer BKL1 so as to cover the first bank layer BKL1. The third bank layer BKL3 may be formed on the entire surface of the semiconductor substrate SSUB including the second bank layer BKL2 so as to cover the second bank layer BKL2.

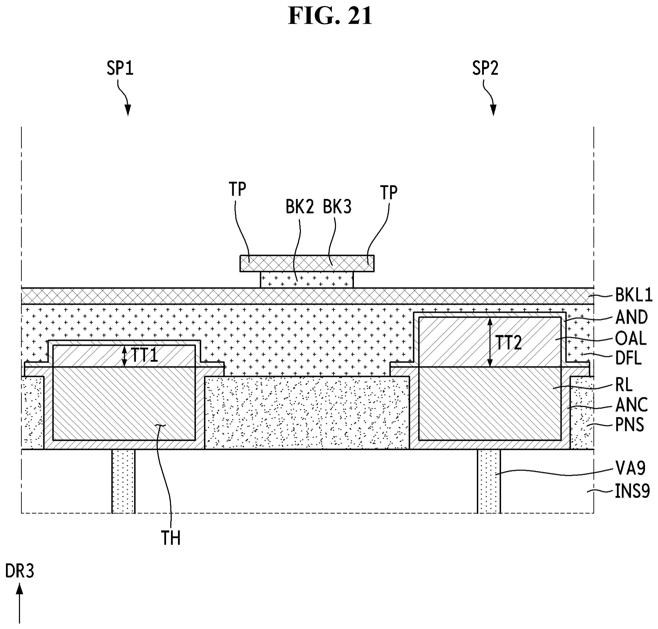

Thereafter, as illustrated in FIG. 21, a second bank BK2, and a third bank BK3 may be formed on the first bank layer BKL1 by removing the third bank layer BKL3 and the second bank layer BKL2 in an area overlapping the optical auxiliary layers OAL. In this case, because the second bank layer BKL2, which is located lower than the third bank layer BKL3, has a higher etching rate than the third bank layer BKL3, the second bank layer BKL2 may be etched more rapidly than the third bank layer BKL3 during the etching process. Accordingly, after etching (e.g., over etching) is completed, an area of the second bank BK2 may become smaller than an area of the third bank BK3. Therefore, a structure including the second bank BK2 and the third bank BK3 may have a shape of a reverse taper. As the second bank layer BKL2 and the third bank layer BKL3 are removed, the first bank layer BKL1 may be exposed in the area overlapping the optical auxiliary layers OAL.

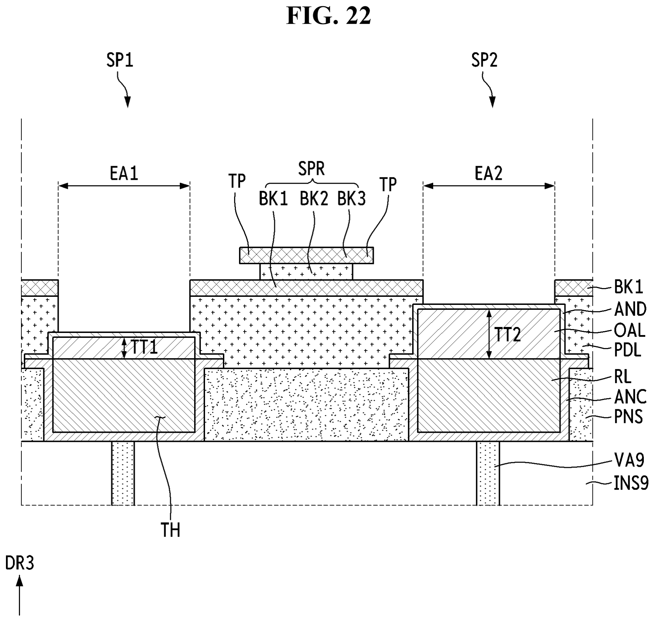

Next, as illustrated in FIG. 22, a first bank BK1 and a pixel-defining layer PDL may be formed by removing the first bank layer BKL1 and the defining layer DFL in the area overlapping the first electrode AND. For example, a pixel-defining layer PDL defining a first light-emitting area EA1, a second light-emitting area EA2, and a third light-emitting area EA3 may be formed, and a separator SPR including first to third banks BK1 to BK3 may be formed. Accordingly, the first electrode AND may be exposed to each of the sub-pixels SP1, SP2, and SP3 through the first light-emitting area EA1, the second light-emitting area EA2, and the third light-emitting area EA3.

Thereafter, as illustrated in FIG. 8, a light-emitting stack IL may be formed on the first electrodes AND and the separator SPR, a second electrode CAT may be formed on the light-emitting stack IL, and an encapsulation layer TFE may be formed on the second electrode CAT. Here, the light-emitting stack IL may be separated for each of the sub-pixels SP1, SP2, and SP3 by the separator SPR.

The display device 10 according to various embodiments may be applied to various electronic devices. An electronic device according to one or more embodiments may include the display device 10 described above, and may further include a module or device having additional functions in addition to the display device 10.

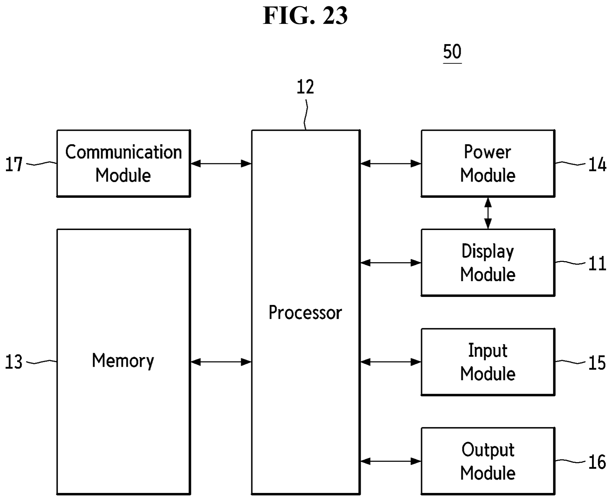

FIG. 23 is a block diagram of an electronic display device according to one or more embodiments. Referring to FIG. 23, an electronic device 50 according to one or more embodiments may include a display module 11, a processor 12, a memory 13, and a power module 14. The electronic device 50 may further include an input module 15, a non-image output module 16, and/or a communication module 17.

The electronic device 50 may output various information in the form of an image through the display module 11. When the processor 12 executes an application stored in the memory 13, image information provided by the application may be provided to the user through the display module 11. The power module 14 may include a power supply module, such as a power adapter or a battery device, and a power conversion module that converts power supplied by the power supply module to generate power required for an operation of the electronic device 50. The input module 15 may provide input information to the processor 12 and/or the display module 11. The non-image output module 16 may serve to receive information other than the image received from the processor 12, such as sound, haptics, and light emission, and may provide the information to the user. The communication module 17 is a module responsible for transmitting and receiving information between the electronic device 50 and an external device, and may include a receiving unit and a transmitting unit.

At least one of the components of the electronic device 50 described above may be included in the display device according to the above-described embodiments. In addition, some of the individual modules functionally included within one module may be included within the display device, while others may be provided separately from the display device. For example, the display device includes the display module 11, and the processor 12, the memory 13, and the power module 14 may be provided in the form of other devices within the electronic device 50 other than the display device.

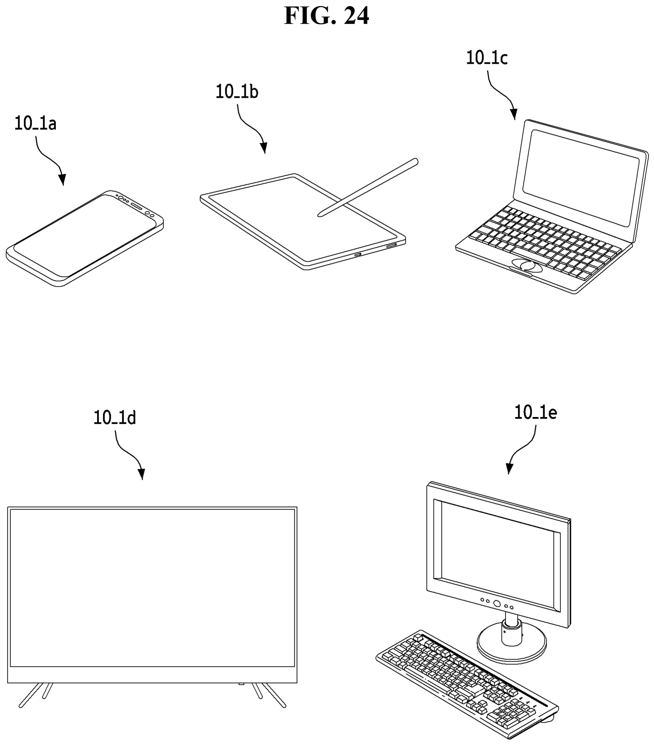

FIGS. 24, 25, and 26 are schematic diagrams of electronic devices according to various embodiments. FIGS. 24 to 26 illustrate examples of various electronic devices to which the display device 10 according to the embodiments is applied.

FIG. 24 illustrates examples of the electronic devices, including a smartphone 10_1a, a tablet PC 10_1b, a laptop 10_1c, a TV 10_1d, and/or a desk monitor 10_1e.

The smartphone 10_1a may include an input module, such as a touch sensor and a communication module, in addition to the display module 11. The smartphone 10_1a may process information received through the communication module or other input modules and display the information through the display module of the display device.

The tablet PC 10_1b, the laptop 10_1c, the TV 10_1d, and the desk monitor 10_1e also include a display module and an input module similarly to the smartphone 10_1a, and in some cases, may further include a communication module.

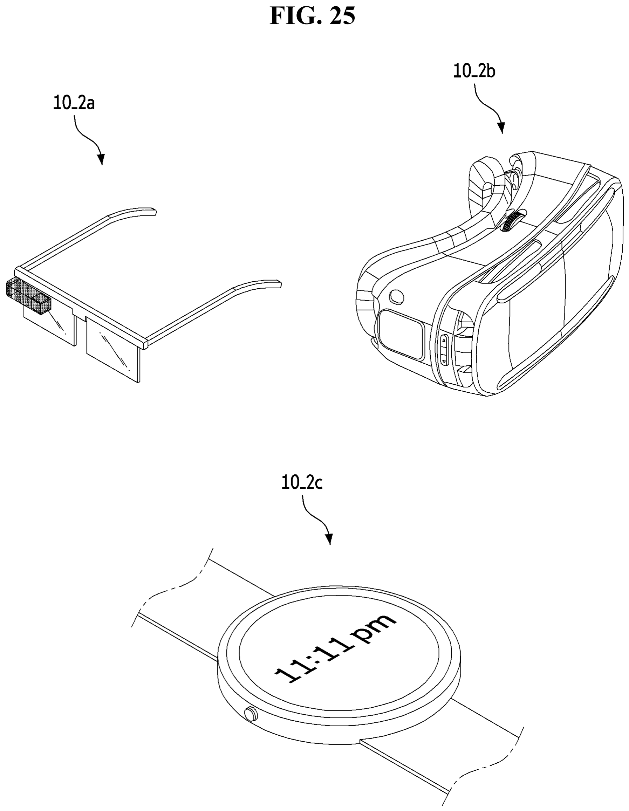

FIG. 25 illustrates an example in which an electronic device including a display module is applied to a wearable electronic device. The wearable electronic device may be smart glasses 10_2a, a head-mounted display 10_2b, a smart watch 10_2c, etc.

The smart glasses 10_2a and the head-mounted display 10_2b may include a display module that emits a display image and a reflector that reflects the emitted display image and provides the reflected display image to the user's eyes, and may provide the user with a virtual reality or augmented reality screen through the display module and the reflector.

The smart watch 10_2c includes a biometric sensor as an input device, and may provide the biometric information recognized by the biometric sensor to the user through the display module.

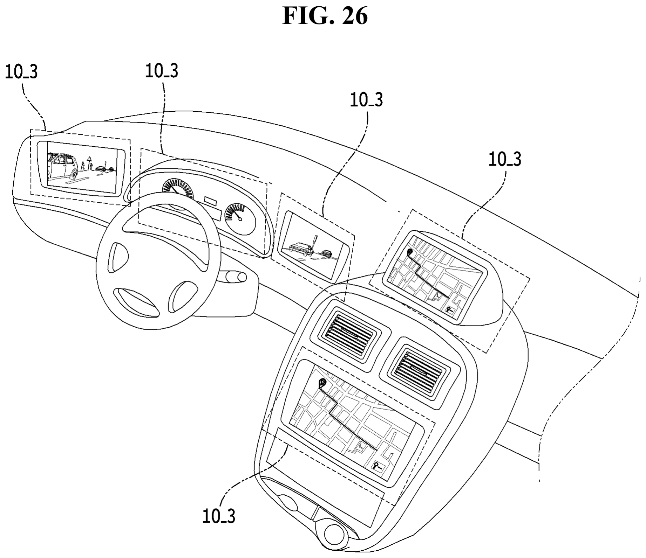

FIG. 26 illustrates an example in which an electronic device including a display module is applied to a vehicle. For example, an electronic device 10_3 may be applied to a dashboard, center fascia, etc. of an automobile, or may be applied to a Center Information Display (CID) located on the dashboard of the automobile or a room mirror display replacing a side mirror.

In concluding the detailed description, those skilled in the art will appreciate that many variations and modifications can be made to the embodiments without substantially departing from the aspects of the present disclosure. Therefore, the disclosed embodiments are used in a generic and descriptive sense only and not for purposes of limitation.

## Claims

1. A display device (10) comprising:
a substrate (SSUB);
an insulating layer (INS9) above the substrate (SSUB);
a via electrode (VA9) within a via hole of the insulating layer (INS9);
a planarization layer (PNS) defining a through hole (TH) overlapping the via electrode (VA9) and a portion of the insulating layer (INS9) around the via electrode (VA9);
a connection electrode (ANC) above the planarization layer (PNS) in the through hole (TH);
a reflective electrode (RL) above the connection electrode (ANC) in the through hole (TH);
an optical auxiliary layer (OAL) above the reflective electrode (RL);
a first electrode (AND) above the optical auxiliary layer (OAL), and having an edge facing an edge of the connection electrode (ANC) and contacting the edge of the connection electrode (ANC) without a step;
a light-emitting stack (IL) above the first electrode (AND); and
a second electrode (CAT) above the light-emitting stack (IL).

2. The display device (10) of claim 1, wherein the edge of the first electrode (AND) is above the edge of the connection electrode (ANC).

3. The display device (10) of claim 1 or claim 2, wherein the connection electrode (ANC) comprises:
a first lower electrode (Ca) above the via electrode (VA9) and the insulating layer (INS9) within the through hole (TH) of the planarization layer (PNS);
a first side electrode (Cb) on an inner wall defining the through hole (TH) of the planarization layer (PNS), and connected to the first lower electrode (Ca); and
a first upper electrode (Cc) above the planarization layer (PNS), and connected to the first side electrode (Cb), and
wherein the edge of the connection electrode (ANC) comprises the first upper electrode (Cc).

4. The display device (10) of claim 3, wherein the first electrode (AND) comprises:
a second lower electrode (Dc) above the first upper electrode (Cc) of the connection electrode (ANC);
a second side electrode (Db) on a side surface of the optical auxiliary layer (OAL), and connected to the second lower electrode (Dc); and
a second upper electrode (Da) above an upper surface of the optical auxiliary layer (OAL), and connected to the second side electrode (Db), and
wherein the edge of the first electrode (AND) comprises the second lower electrode (Dc).

5. The display device (10) of claim 4, wherein the second lower electrode (Dc) and the first upper electrode (Cc) face each other, and contact each other without a step.

6. The display device (10) of claim 5, wherein an interface between the second lower electrode (Dc) and the first upper electrode (Cc) is aligned with an interface between the optical auxiliary layer (OAL) and the reflective electrode (RL).

7. The display device (10) of claim 5, wherein an interface between the second lower electrode (Dc) and the first upper electrode (Cc) and an interface between the optical auxiliary layer (OAL) and the reflective electrode (RL) extend along an imaginary straight line.

8. The display device (10) of any one of claims 3 to 7, wherein:
(i) the first lower electrode (Ca) is on a lower surface of the reflective electrode (RL), and
wherein the first side electrode (Cb) is on a side surface of the reflective electrode (RL); and/or
(ii) the first upper electrode (Cc) surrounds the reflective electrode (RL) in plan view.

9. The display device (10) of any one of claims 4 to 8, wherein:
(i) the second lower electrode (Dc) is above the first upper electrode (Cc) and surrounds the optical auxiliary layer (OAL) in plan view; and/or
(ii) a thickness of the second side electrode (Db) is less than a thickness of the second upper electrode (Da).

10. The display device (10) of any one of claims 1 to 9, wherein:
(i) the reflective electrode (RL) is surrounded by the connection electrode (ANC) and the optical auxiliary layer (OAL); and/or
(ii) the optical auxiliary layer (OAL) is surrounded by the first electrode (AND) and the reflective electrode (RL).

11. The display device (10) of any one of claims 1 to 10, wherein:
(i) the optical auxiliary layer (OAL) has different respective thicknesses (TT1, TT2) for multiple sub-pixels (SP1, SP2, SP3); and/or
(ii) the display device (10) further comprises:
a pixel-defining layer (PDL) defining a light-emitting area (EA1, EA2, EA3) above the first electrode (AND); and
a separator (SPR) above the pixel-defining layer (PDL),
wherein the light-emitting stack (IL) is cut along the separator (SPR).

12. An electronic device (50) comprising:
a display device (10) for providing a display screen, and comprising:
a substrate (SSUB);
an insulating layer (INS9) above the substrate (SSUB);
a via electrode (VA9) within a via hole of the insulating layer (INS9);
a planarization layer (PNS) defining a through hole (TH) overlapping the via electrode (VA9) and a portion of the insulating layer (INS9) around the via electrode (VA9);
a connection electrode (ANC) above the planarization layer (PNS) and in the through hole (TH) of the planarization layer (PNS);
a reflective electrode (RL) above the connection electrode (ANC) and in the through hole (TH);
an optical auxiliary layer (OAL) above the reflective electrode (RL);
a first electrode (AND) above the optical auxiliary layer (OAL), and having an edge facing an edge of the connection electrode (ANC) and contacting the edge of the connection electrode (ANC) without a step;
a light-emitting stack (IL) above the first electrode (AND); and
a second electrode (CAT) above the light-emitting stack (IL).

13. The electronic device (50) of claim 12, wherein:
(i) the connection electrode (ANC) comprises:
a first lower electrode (Ca) above the via electrode (VA9) and the insulating layer (INS9) in the through hole (TH) of the planarization layer (PNS);
a first side electrode (Cb) on an inner wall defining the through hole (TH) of the planarization layer (PNS), and connected to the first lower electrode (Ca); and
a first upper electrode (Cc) above the planarization layer (PNS), and connected to the first side electrode (Cb), and
wherein the edge of the connection electrode (ANC) comprises the first upper electrode (Cc); and/or
(ii) the first electrode (AND) comprises:
a second lower electrode (Dc) above the first upper electrode (Cc) of the connection electrode (ANC);
a second side electrode (Db) on a side surface of the optical auxiliary layer (OAL), and connected to the second lower electrode (Dc); and
a second upper electrode (Da) above an upper surface of the optical auxiliary layer (OAL), and connected to the second side electrode (Db),
wherein the edge of the first electrode (AND) comprises the second lower electrode (Dc), and
wherein the second lower electrode (Dc) and the first upper electrode (Cc) contact each other without a step.

14. The electronic device (50) of claim 12 or claim 13, wherein the electronic device (50) comprises a smartphone, a tablet, a laptop, a TV, a desk monitor, smart glasses, a smart watch, a head-mounted display, or a vehicle.

15. A method for fabricating a display device (10), the method comprising:
forming an insulating layer (INS9) having a via electrode (VA9) therein above a substrate (SSUB);
forming a planarization layer (PNS) above the via electrode (VA9) and the insulating layer (INS9);
forming a through hole (TH) in the planarization layer (PNS) that exposes the via electrode (VA9) and a portion of the insulating layer (INS9) around the via electrode (VA9);
forming a connection electrode layer (ANCL) above the planarization layer (PNS), above the via electrode (VA9) the portion of the insulating layer (INS9) exposed through the through hole (TH), and on an inner wall defining the through hole (TH);
forming a reflective electrode layer (RLL) above the connection electrode layer (ANCL);
forming a reflective electrode (RL) in the through hole (TH) by removing a portion of the reflective electrode layer (RLL) above the planarization layer (PNS);
forming a connection electrode (ANC) inside the through hole (TH) by removing a portion of the connection electrode layer (ANCL) above the planarization layer (PNS);
forming an optical auxiliary layer (OAL) above the reflective electrode (RL);
forming a first electrode (AND) above the optical auxiliary layer (OAL) and having an edge facing an edge of the connection electrode (ANC) and contacting the edge of the connection electrode (ANC) without a step;
forming a light-emitting stack (IL) above the first electrode (AND); and
forming a second electrode (CAT) above the light-emitting stack (IL).
